# EUROPEAN PATENT SPECIFICATION

(11) **EP 4 170 000 B1**
(45) Date of publication and mention of the grant of the patent: **11.02.2026**
(21) Application number: 20946216.7
(22) Date of filing: 27.07.2020
(51) Int. Cl.: C09K 11/06, H10K 85/60, H10K 50/11, H10K 50/12

(54) **POLYCYCLIC AROMATIC DERIVATIVE COMPOUND AND ORGANIC LIGHT-EMITTING ELEMENT USING THE SAME**
POLYCYCLISCHE AROMATISCHE DERIVATVERBINDUNG UND ORGANISCHES LICHTEMITTIERENDES ELEMENT DAMIT
COMPOSÉ D'UN DÉRIVÉ POLYCYCLIQUE AROMATIQUE ET ÉLÉMENT ÉLECTROLUMINESCENT ORGANIQUE L'UTILISANT

(30) Priority: 24.07.2020 KR 20200092566
(43) Date of publication of application: 26.04.2023
(73) Proprietor: SFC Co., Ltd., Cheongju-si, Chungcheongbuk-do 28122 (KR)
(72) Inventor: JOO, Sung-hoon, Cheongju-si, Chungcheongbuk-do 28122 (KR); KIM, Ji-hwan, Cheongju-si, Chungcheongbuk-do 28122 (KR); YANG, Byung-sun, Cheongju-si, Chungcheongbuk-do 28122 (KR); JO, Hyeon-jun, Cheongju-si, Chungcheongbuk-do 28122 (KR); CHOI, Sung-eun, Cheongju-si, Chungcheongbuk-do 28122 (KR); SHIN, Bong-ki, Cheongju-si, Chungcheongbuk-do 28122 (KR)
(74) Representative: Grosse, Felix Christopher
(86) International application number: PCT/KR2020/095093
(87) International publication number: WO 2022/019414

(56) References cited:
- WO-A1-2019/164331
- CN-A- 110 790 782
- KR-A- 20170 127 593
- KR-A- 20180 018 404
- KR-A- 20180 108 559
- KR-A- 20190 042 791
- KR-A- 20200 066 208
- KR-B1- 101 990 818
- US-A1- 2019 207 112

## Description

### Technical Field

The present invention relates to a polycyclic aromatic derivative compound and a highly efficient and long-lasting organic light-emitting device with remarkably improved luminous efficacy using the same.

### Background Art

An organic light-emitting device is a self-luminous device that emits light when energy is released from excitons which are formed by recombination of electrons injected from an electron injection electrode (cathode) and holes injected from a hole injection electrode (anode) in a light-emitting layer. Such an organic light-emitting device attracts a great deal of attention as a next-generation light source due to applicability to full-color flat panel light-emitting displays based on advantages such as low driving voltage, high luminance, wide viewing angle, and rapid response speed thereof.

In order for the organic light-emitting device to exhibit the characteristics, the structure of the organic layer in the organic light-emitting device should be optimized, and the material constituting each organic layer, namely, a hole injection material, a hole transport material, a light-emitting material, an electron transport material, an electron injection material, or an electron blocking material should be based on stable and efficient ingredients. However, there is a continuing need to develop organic layer structures and respective materials thereof for stable and efficient organic light-emitting devices.

In each of CN110790782A1, WO2019/164331A1 and KR20200066208A, known organic electroluminescent compounds for use in light emitting diodes are described.

In addition, recently, in addition to research on improving the characteristics of an organic light-emitting device by changing the performance of each organic layer material, technology for improving color purity and increasing luminous efficacy by optimizing the optical thickness between an anode and a cathode is considered as an important factor to improve performance. As an example of this method, a desired luminous efficacy and excellent color purity can be obtained using a capping layer for an electrode.

As such, there is a continuing need for the development of the structure of an organic light-emitting device capable of improving the luminous characteristics thereof and the development of novel materials supporting the structure.

### Technical Problem

Therefore, the present invention has been made in view of the above problems and it is one object of the present invention to provide an organic light-emitting compound that can be used in an organic layer of a device to realize a highly efficient organic light-emitting device and an organic light-emitting device including the same.

### Technical Solution

In accordance with the present invention, the above and other objects can be accomplished by the provision of an organic light-emitting compound represented by the following [Formula A-1].

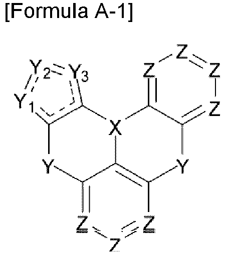

More specific structures of [Formula A-1] and [Formula B], definitions of Y₁ to Y₃ X, Z and Y, and specific polycyclic aromatic compounds according to the present invention represented by [Formula A-1] will be described later.

In accordance with another aspect of the present invention, provided is an organic light-emitting device including a first electrode, a second electrode facing the first electrode, and an organic layer interposed between the first electrode and the second electrode, wherein the organic layer includes at least one of polycyclic aromatic compounds represented by [Formula A-1].

### Advantageous Effects

The polycyclic aromatic compound according to the present invention can be used for an organic layer in a device to realize a highly efficient and long-lasting organic light-emitting device.

### Brief Description of Drawings

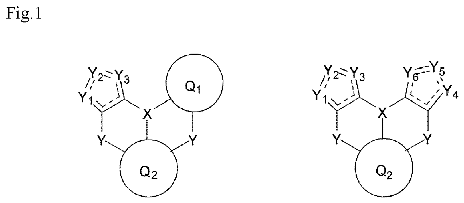

FIG. 1 is a representative view illustrating the structure of an aromatic derivative compound according to the present invention.

Hereinafter, the present invention will be described in detail with reference to the annexed drawings. The present invention is directed to a polycyclic aromatic derivative compound that is included in an organic light-emitting device, is represented by the following [Formula A-1], and is capable of realizing a highly efficient organic light-emitting device with greatly improved lifespan, 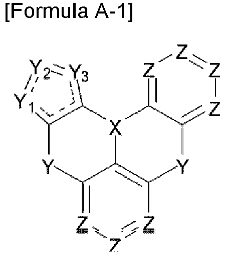 wherein
Y₁ and Y₁ to Y₃ are each independently selected from N-R₁, CR₂R₃, O, S, Se, and SiR₄R₅, with the proviso that Y's, and Y₁'s to Y₃'s are identical to or different from each other, and the dotted lines represent a single bond or a double bond according to the definition of Y₁ to Y₃, and
X is selected from B, P, and P=O, in a preferred embodiment of the present invention, X is B, and a highly efficient and long-lasting organic light-emitting device can be realized based on the structure of the polycyclic aromatic derivative compound containing boron (B).
R₁ to R₅ are identical to or different from each other and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthio group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, and a halogen group.
Z is CR or N, wherein R is selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C2-C30 arylheteroarylamine group, a substituted or unsubstituted C1-C30 alkylsilyl group, a substituted or unsubstituted C5-C30 arylsilyl group, a nitro group, a cyano group, and a halogen (with the proviso that Z's and R's are identical to or different from each other).

According to an embodiment of the present invention, all of Z's may be CR, and at least one of Z's may be N' in order to satisfy desired conditions for various organic material layers of the organic light-emitting device.

R's may be bonded to each other or may be linked to an adjacent substituent to form an alicyclic or aromatic monocyclic or polycyclic ring, and the carbon atom of the formed alicyclic or aromatic monocyclic or polycyclic ring may be substituted with at least one heteroatom selected from N, S and O.

R's may be bonded to Y to further form an alicyclic or aromatic monocyclic or polycyclic ring.

As used herein, the term "substituted" in the definition of R, and R₁ to R₉ in Formulae A-1 indicates substitution with one or more substituents selected from deuterium, cyano, halogen, hydroxyl, nitro, C₁-C₂₄ alkyl, C₃-C₂₄ cycloalkyl, C₁-C₂₄ haloalkyl, C₁-C₂₄ alkenyl, C₁-C₂₄ alkynyl, C₁-C₂₄ heteroalkyl, C₁-C₂₄ heterocycloalkyl, C₆-C₂₄ aryl, C₆-C₂₄ arylalkyl, C₂-C₂₄ heteroaryl, C₂-C₂₄ heteroarylalkyl, C₁-C₂₄ alkoxy, C₁-C₂₄ alkylamino, C₁-C₂₄ arylamino, C₁-C₂₄ heteroarylamino, C₁-C₂₄ alkylsilyl, C₁-C₂₄ arylsilyl, and C₁-C₂₄ aryloxy, or a combination thereof. As used herein, the term "unsubstituted" indicates having no substituent.

In the "substituted or unsubstituted C₁-C₁₀ alkyl", "substituted or unsubstituted C₆-C₃₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "form a ring with an adjacent substituent" means that the corresponding substituent combines with an adjacent substituent to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other.

The alkyl groups may be straight or branched, and the numbers of carbon atoms therein are not particularly limited but are preferably 1 to 20. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkyl group is intended to include monocyclic and polycyclic ones and may be optionally substituted with one or more other substituents. As used herein, the term "polycyclic" means that the cycloalkyl group may be directly attached or fused to one or more other cyclic groups. The other cyclic groups may be cycloalkyl groups and other examples thereof include heterocycloalkyl, aryl, and heteroaryl groups. The cycloalkyl group may be specifically a cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl or cyclooctyl group but is not limited thereto.

The heterocycloalkyl group is intended to include monocyclic and polycyclic ones interrupted by a heteroatom such as O, S, Se, N or Si and may be optionally substituted with one or more other substituents. As used herein, the term "polycyclic" means that the heterocycloalkyl group may be directly attached or fused to one or more other cyclic groups. The other cyclic groups may be heterocycloalkyl groups and other examples thereof include cycloalkyl, aryl, and heteroaryl groups.

The aryl groups may be monocyclic or polycyclic ones. Examples of the monocyclic aryl groups include, but are not limited to, phenyl, biphenyl, terphenyl, and stilbenyl groups. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups but the scope of the present invention is not limited thereto.

The heteroaryl groups refer to heterocyclic groups interrupted by one or more heteroatoms. Examples of the heteroaryl groups include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The mixed aliphatic-aromatic ring refers to a ring in which at least one aliphatic ring and at least one aromatic ring are linked or fused together and which is overall non-aromatic. The mixed aliphatic-aromatic polycyclic ring may contain one or more heteroatoms selected from N, O, P, and S other than carbon atoms (C).

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include alkyl-substituted silyl groups and aryl-substituted silyl groups. Specific examples of such silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The amine groups may be, for example, -NH₂, alkylamine groups, and arylamine groups. The arylamine groups are aryl-substituted amine groups and the alkylamine groups are alkyl-substituted amine groups. Examples of the arylamine groups include substituted or unsubstituted monoarylamine groups, substituted or unsubstituted diarylamine groups, and substituted or unsubstituted triarylamine groups. The aryl moieties in the arylamine groups may be monocyclic or polycyclic ones. The arylamine groups may include two or more aryl moieties. In this case, the aryl moieties may be monocyclic or polycyclic ones. Alternatively, the aryl moieties may consist of a monocyclic aryl moiety and a polycyclic aryl moiety. The aryl moieties in the arylamine groups may be selected from those exemplified above.

The aryl moieties in the aryloxy group and the arylthioxy group are the same as those described above for the aryl groups. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. The arylthioxy group may be, for example, a phenylthioxy, 2-methylphenylthioxy or 4-tert-butylphenylthioxy group but is not limited thereto.

The halogen group may be, for example, fluorine, chlorine, bromine or iodine.

More specifically, the polycyclic aromatic derivative compound represented by [Formula A-1] according to the present invention may be selected from the following [Compound 1] to [Compound 116], specific substituents can be clearly identified therefrom and these compounds should not be construed as limiting the scope of [Formula A-1] according to the present invention.

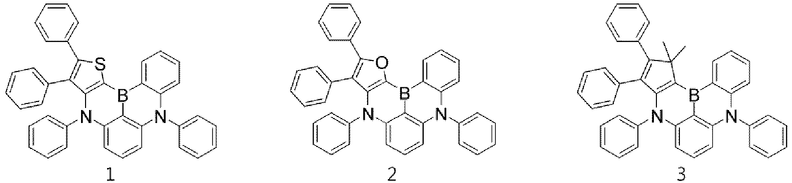

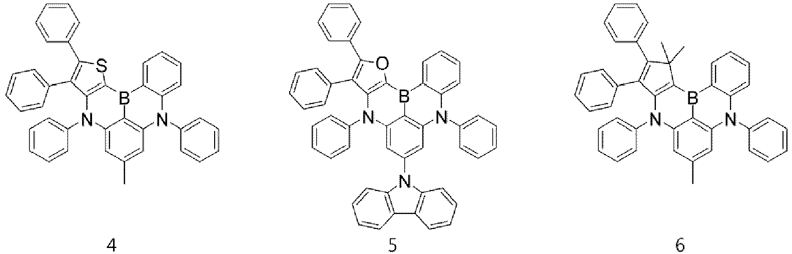

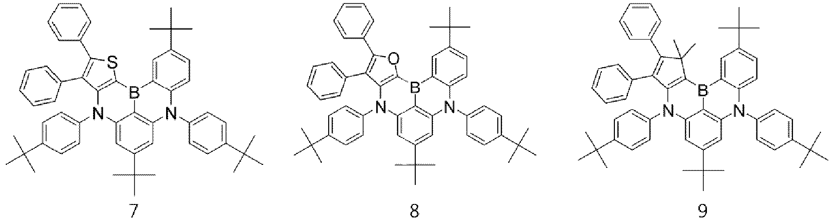

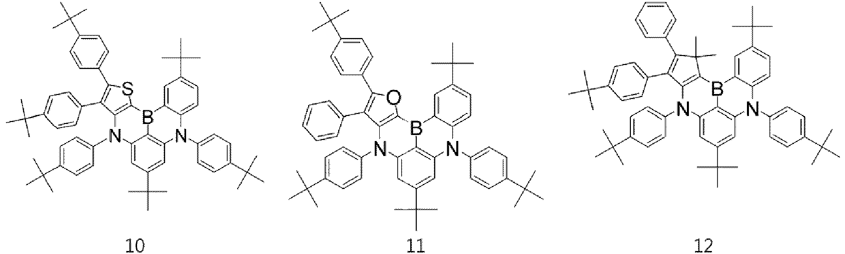

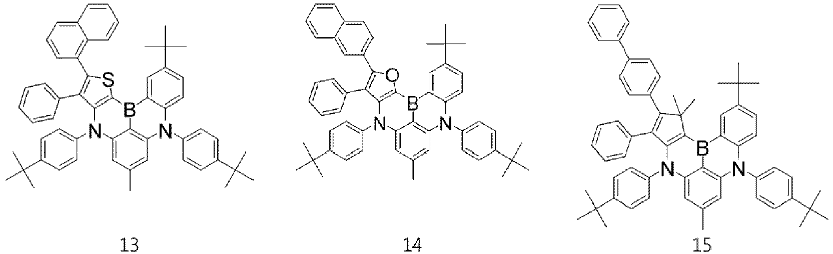

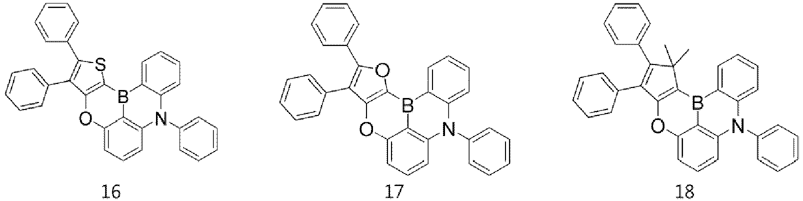

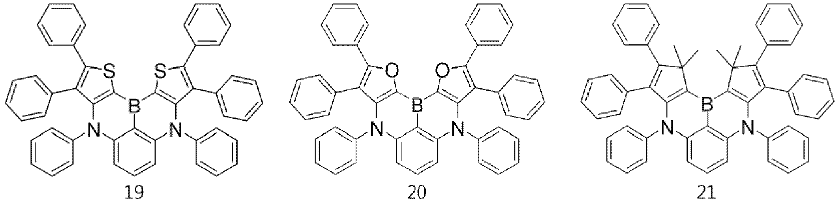

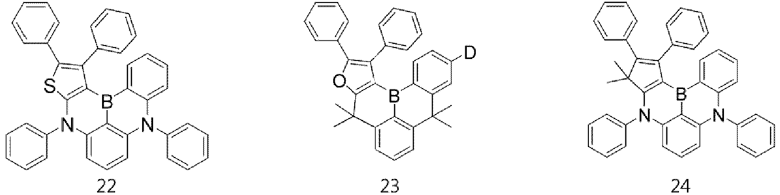

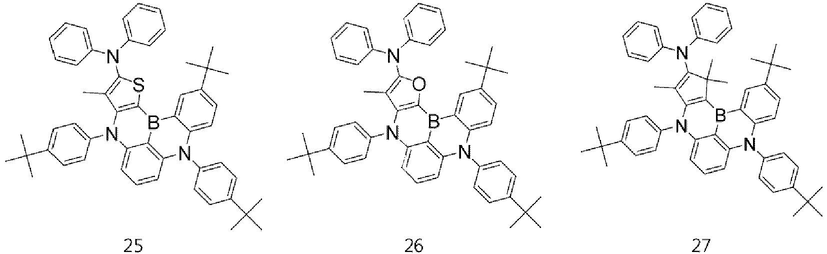

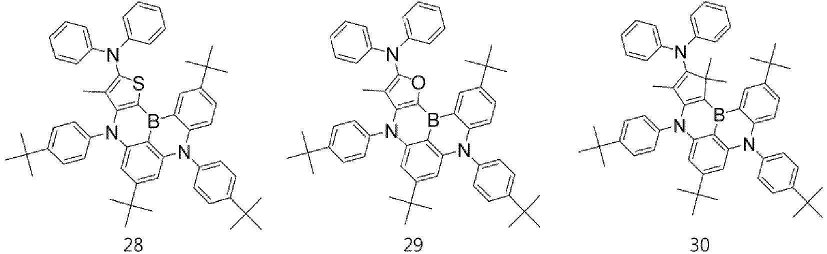

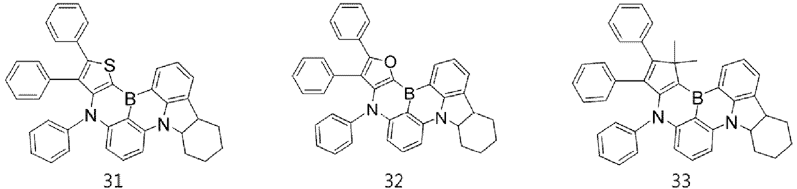

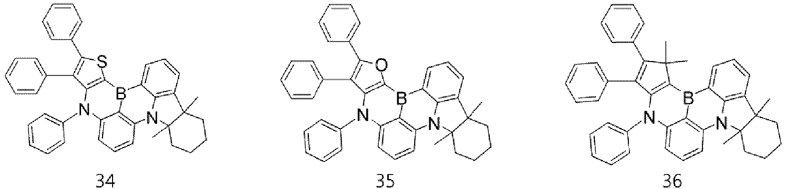

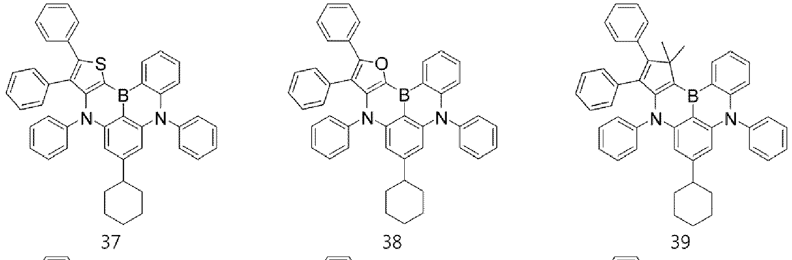

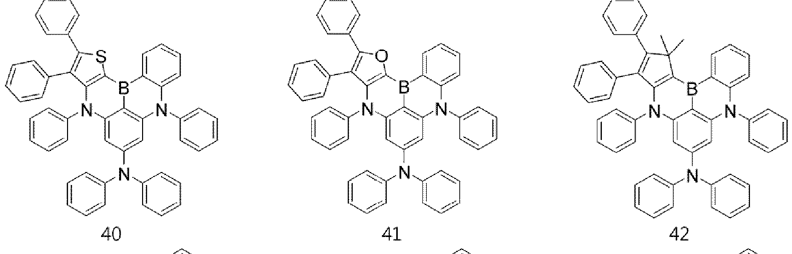

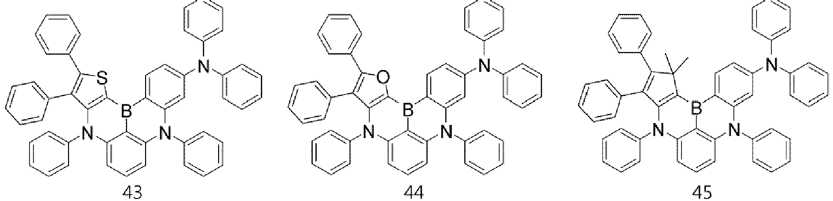

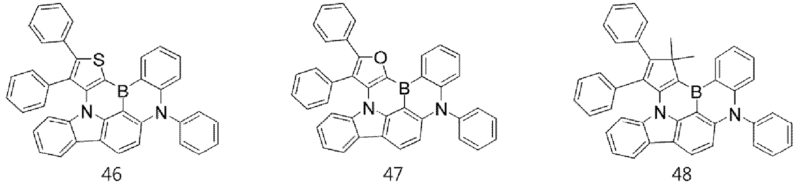

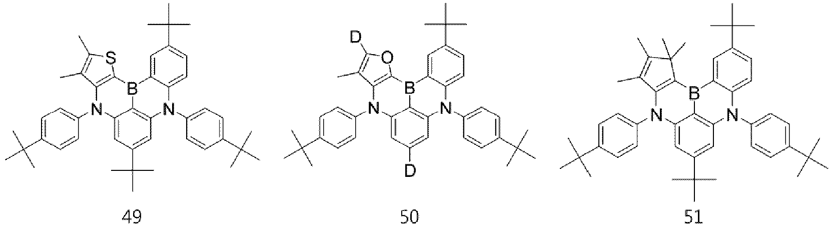

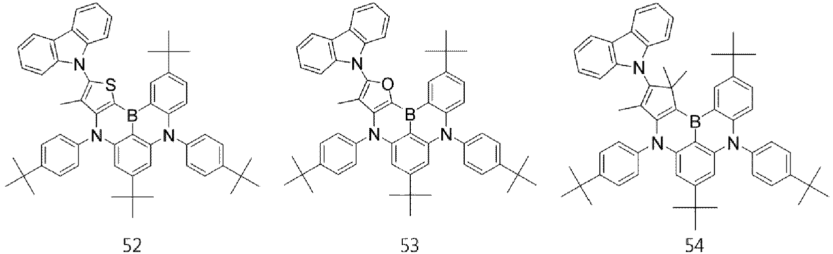

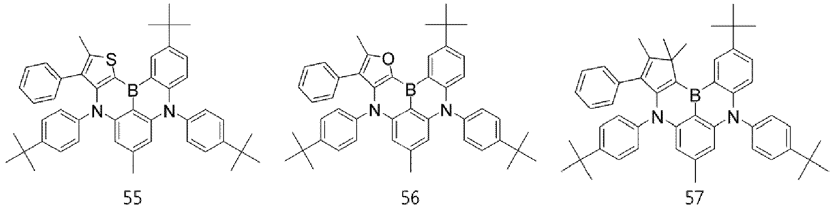

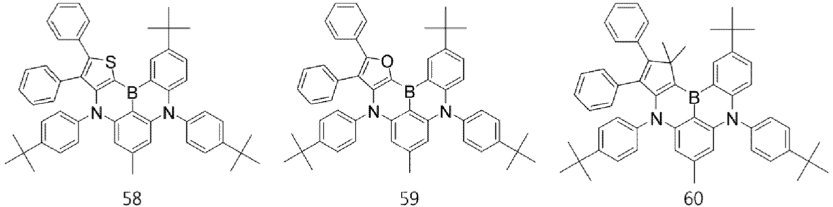

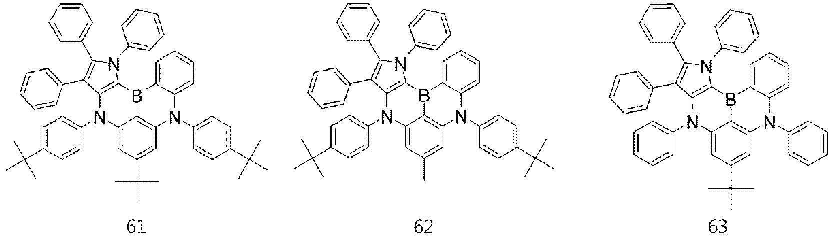

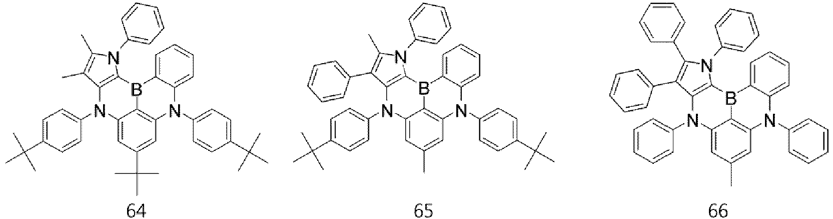

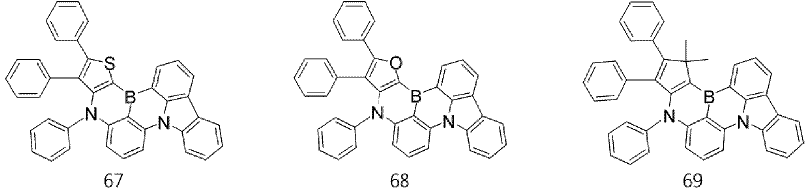

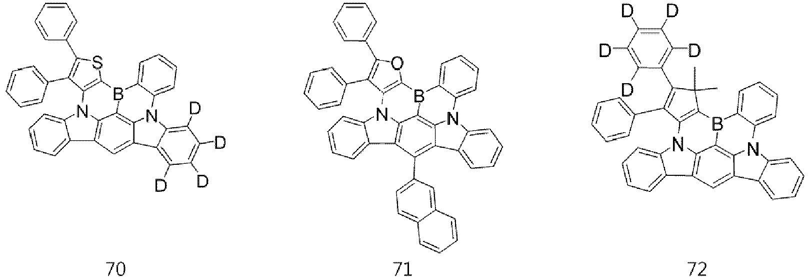

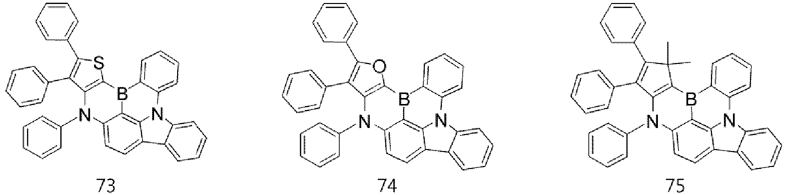

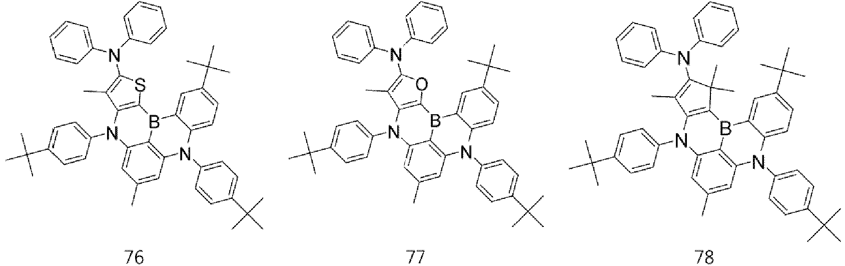

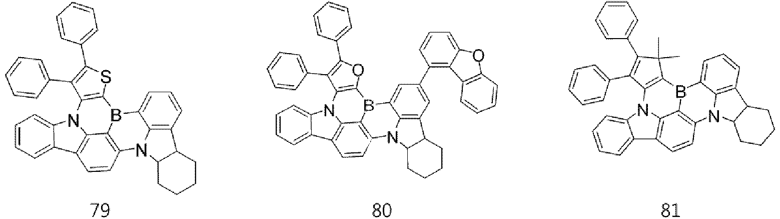

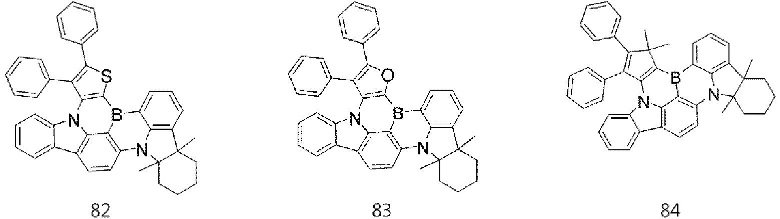

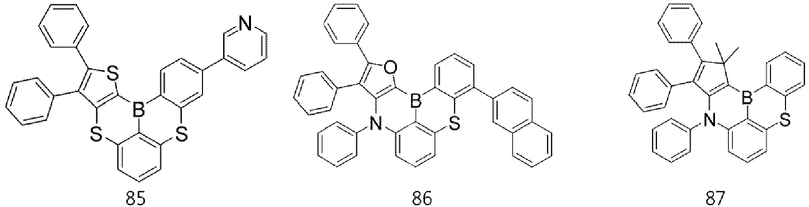

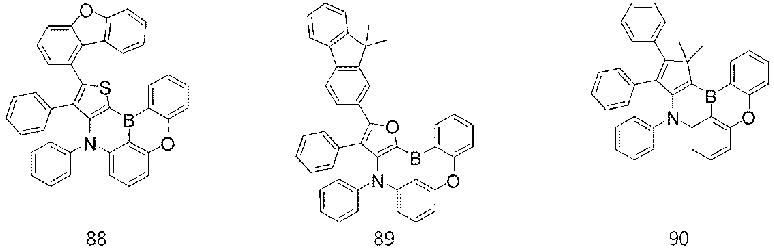

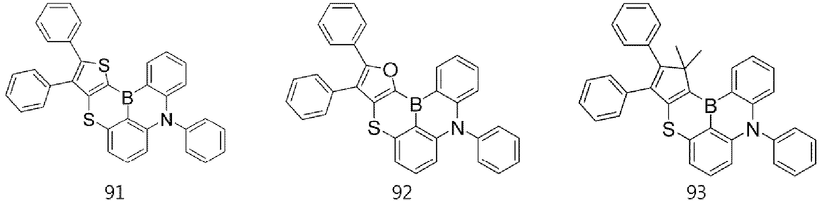

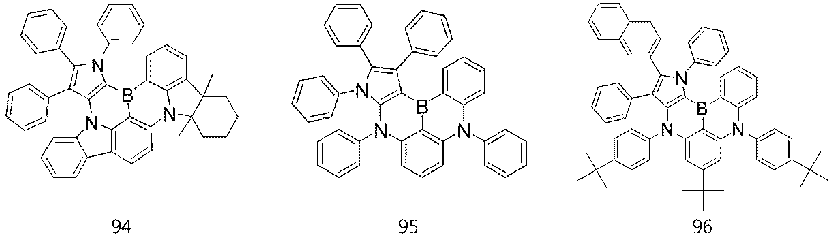

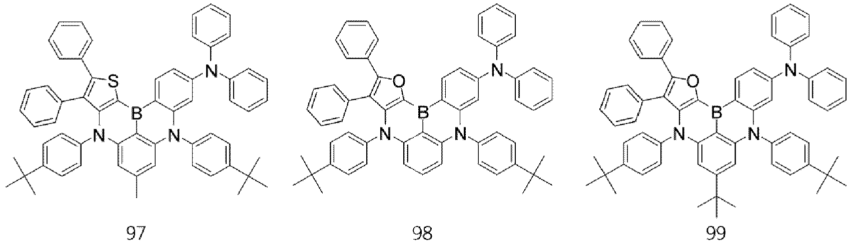

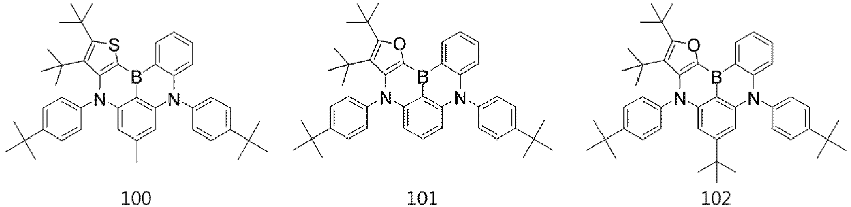

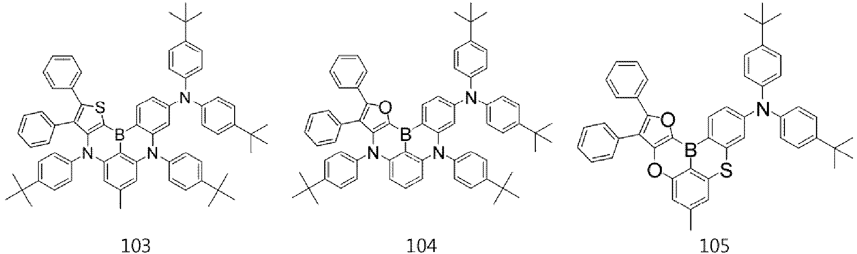

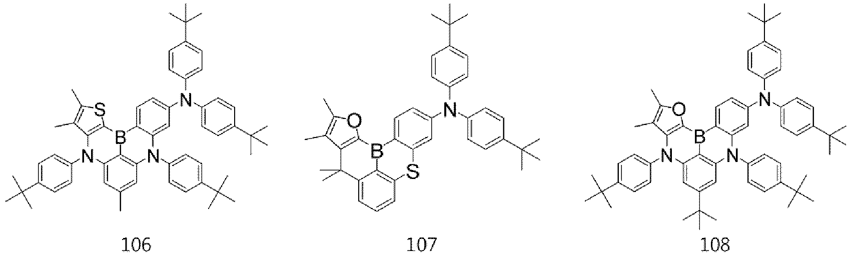

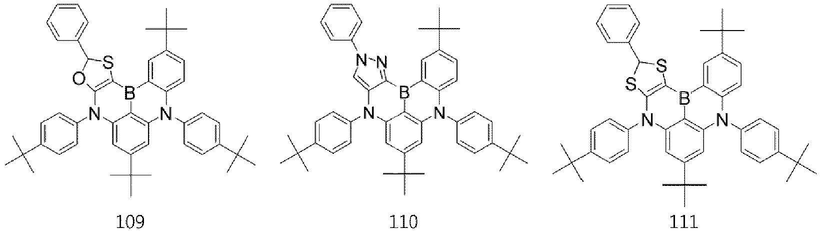

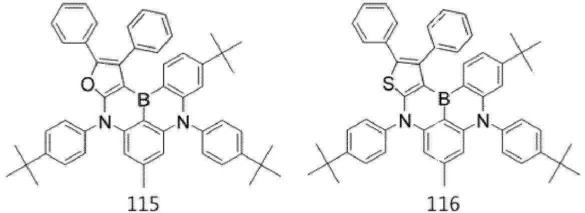

As can be seen from the specific compounds, a polycyclic aromatic structure including B, P, P=O, or the like is formed and substituents are introduced thereinto, thereby synthetizing organic light-emitting materials having intrinsic characteristics of the substituents. For example, by introducing, into the structures, substituents used for materials for a hole injection layer, a hole transport layer, a light-emitting layer, an electron transport layer, an electron injection layer, an electron blocking layer, a hole blocking layer, and the like used in the manufacture of the organic light-emitting device, organic light-emitting materials that satisfy the requirements for respective organic layers can be produced. Based thereon, highly efficient organic light-emitting devices can be realized. In addition, the compound according to the present invention can be useful as a material for various organic layers singly or in combination with other compounds, or can be used for a capping layer (CPL).

In addition, in another aspect, the present invention is directed to an organic light-emitting device including a first electrode, a second electrode, and at least one organic layer interposed between the first electrode and the second electrode, wherein the organic layer includes at least one organic light-emitting compound represented by [Formula A-1] according to the present invention.

That is, the organic light-emitting device according to an embodiment of the present invention may have a structure including a first electrode, a second electrode and at least one organic layer disposed therebetween, and the organic light-emitting device may be manufactured using a conventional method and materials for manufacturing devices, except that the organic light-emitting compound of [Formula A-1] according to the present invention is used in the organic layer of the device.

The organic layer of the organic light-emitting device according to the present invention may have a single layer structure or a multilayer structure in which two or more organic layers are stacked. For example, the organic layer may have a structure including a hole injection layer, a hole transport layer, a hole blocking layer, a light-emitting layer, an electron blocking layer, an electron transport layer, an electron injection layer, and the like. However, the structure of the organic layer is not limited thereto and may include a smaller or larger number of organic layers, and the preferred organic material layer structure of the organic light-emitting device according to the present invention will be described in more detail in Example which will be given later.

In addition, the organic light-emitting device according to an embodiment of the present invention includes a substrate, a first electrode (anode), an organic material layer, a second electrode (cathode), and a capping layer, wherein the capping layer is formed on top of the second electrode (top emission).

In the top-emission manner, the light formed in the light-emitting layer is emitted toward the cathode, and the light emitted toward the cathode passes through the capping layer (CPL) formed of the compound according to the present invention having a relatively high refractive index. At this time, the wavelength is amplified and thus luminous efficacy is increased.

Hereinafter, an embodiment of the organic light-emitting device according to the present invention will be described in more detail.

The organic light-emitting device according to the present invention includes an anode, a hole transport layer, a light-emitting layer, an electron transport layer and a cathode, and if necessary, may further include a hole injection layer between the anode and the hole transport layer, may further include an electron injection layer between the electron transport layer and the cathode, may further include one or two intermediate layers, and may further include a hole blocking layer or an electron blocking layer. As described above, the organic light-emitting device may further include an organic layer having various functions, such as the capping layer described above, depending on characteristics thereof.

As a more preferred embodiment of the present invention, the organic layer interposed between the first electrode and the second electrode includes a light-emitting layer, the light-emitting layer includes a host and a dopant, and the compound according to the present invention represented by [Formula A-1] is included as a dopant in the light-emitting layer.

The light emitting layer of the organic electroluminescent device according to the present invention includes, as a host compound, an anthracene derivative represented by Formula C: 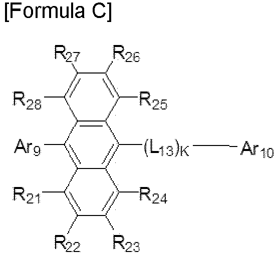 wherein R₂₁ to R₂₈ are identical to or different from each other and are as defined for R₁ to R₁₃ in Formula A-1, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L₁₃ is a single bond or is selected from substituted or unsubstituted C₆-C₂₀ arylene and substituted or unsubstituted C₂-C₂₀ heteroarylene, preferably a single bond or substituted or unsubstituted C₆-C₂₀ arylene, and k is an integer from 1 to 3, provided that when k is 2 or more, the linkers L₁₃ are identical to or different from each other.

Ar₉ in Formula C is represented by Formula C-1: 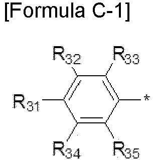 wherein R₃₁ to R₃₅ are identical to or different from each other and are as defined for R₁ to R₁₃ in Formula A-1 and each of R₃₁ to R₃₅ is optionally bonded to an adjacent substituent to form a saturated or unsaturated ring.

The compound of Formula C employed in the organic electroluminescent device of the present invention may be specifically selected from the compounds of Formulae C1 to C48:

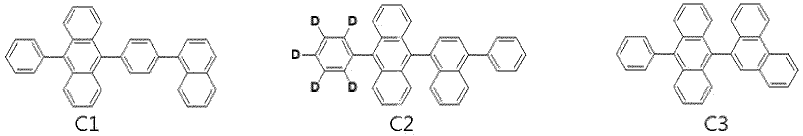

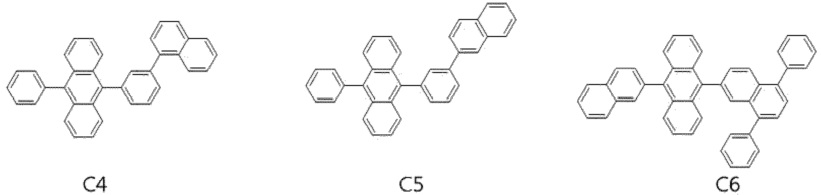

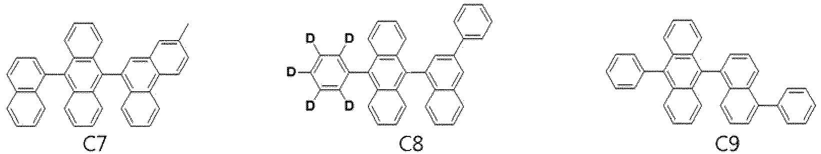

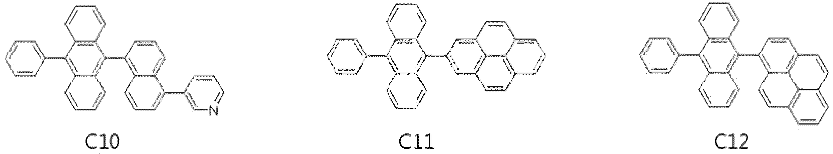

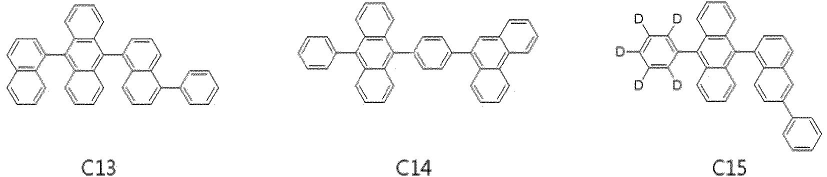

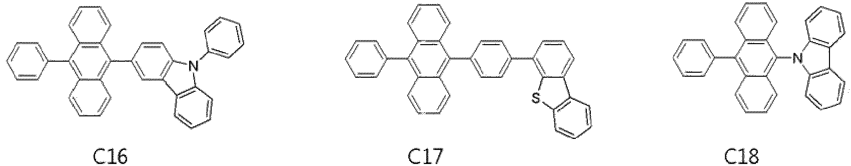

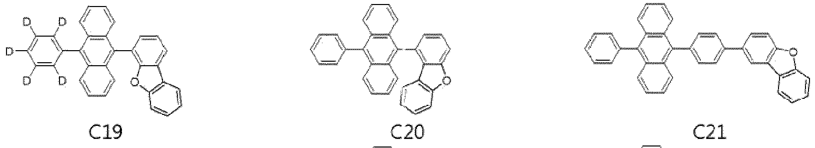

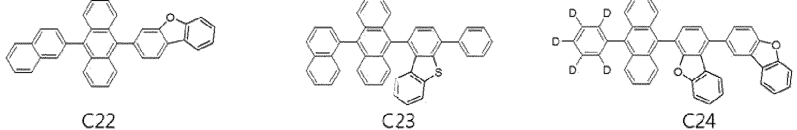

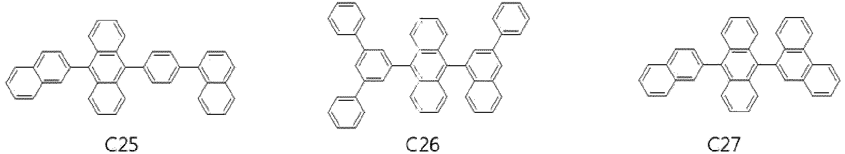

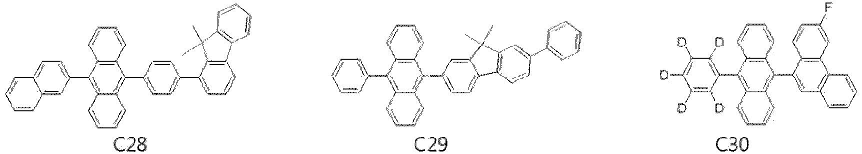

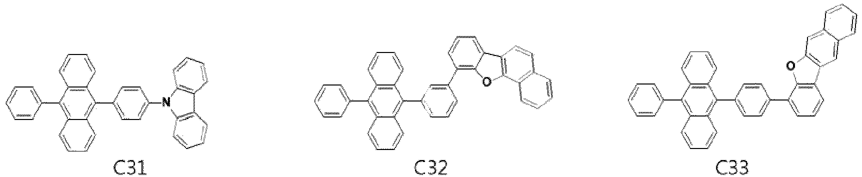

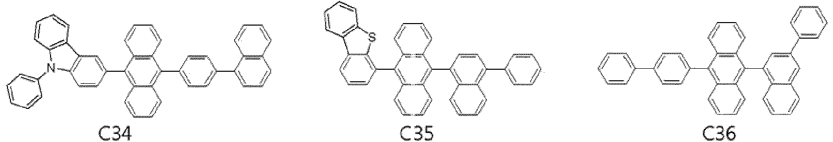

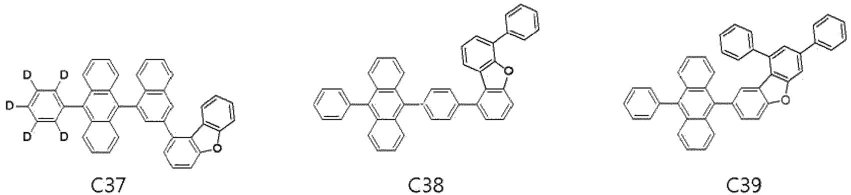

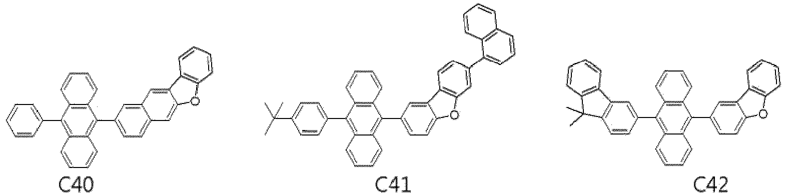

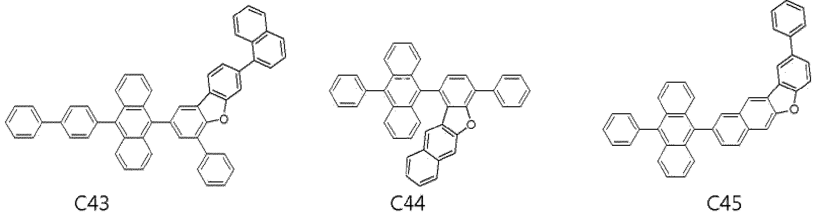

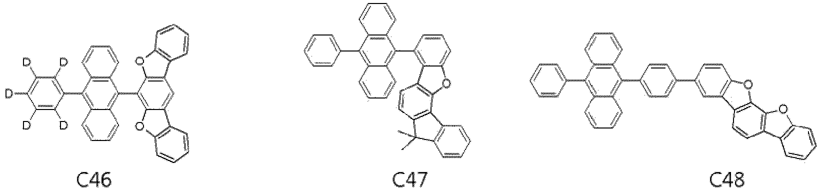

The organic electroluminescent device of the present invention may further include a hole transport layer and an electron blocking layer, each of which may include a compound represented by Formula D: 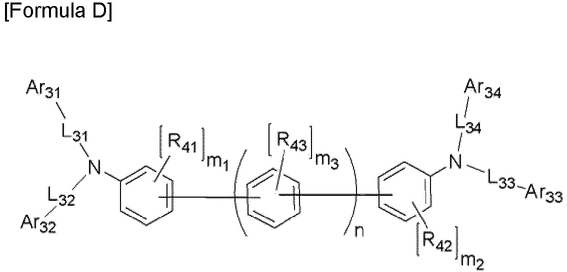 wherein R₄₁ to R₄₃ are identical to or different from each other and are each independently selected from hydrogen, deuterium, substituted or unsubstituted C₁-C₂₀ alkyl, substituted or unsubstituted C₆-C₅₀ aryl, substituted or unsubstituted C₇-C₅₀ arylalkyl, substituted or unsubstituted C₃-C₃₀ cycloalkyl, substituted or unsubstituted C₁-C₃₀ alkylsilyl, substituted or unsubstituted C₆-C₃₀ arylsilyl, and halogen, L₃₁ to L₃₄ are identical to or different from each other and are each independently single bonds or selected from substituted or unsubstituted C₆-C₅₀ arylene and substituted or unsubstituted C₂-C₅₀ heteroarylene, Ar₃₁ to Ar₃₄ are identical to or different from each other and are each independently selected from substituted or unsubstituted C₆-C₅₀ aryl and substituted or unsubstituted C₂-C₅₀ heteroaryl, n is an integer from 0 to 4, provided that when n is 2 or greater, the aromatic rings containing R₄₃ are identical to or different from each other, m₁ to m₃ are integers from 0 to 4, provided that when both m₁ and m₃ are 2 or more, the R₄₁, R₄₂, and R₄₃ groups are identical to or different from each other, and hydrogen or deuterium atoms are bonded to the carbon atoms of the aromatic rings to which R₄₁ to R₄₃ are not attached.

In Formula D, at least one of Ar₃₁ to Ar₃₄ is represented by Formula E: 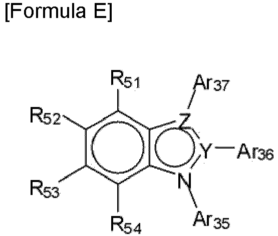 wherein R₅₁ to R₅₄ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, which are optionally linked to each other to form a ring, Y is a carbon or nitrogen atom, Z is a carbon, oxygen, sulfur or nitrogen atom, Ar₃₅ to Ar₃₇ are identical to or different from each other and are each independently selected from substituted or unsubstituted C₅-C₅₀ aryl and substituted or unsubstituted C₃-C₅₀ heteroaryl, provided that when Z is an oxygen or sulfur atom, Ar₃₇ is nothing, provided that when Y and Z are nitrogen atoms, only one of Ar₃₅, Ar₃₆, and Ar₃₇ is present, provided that when Y is a nitrogen atom and Z is a carbon atom, Ar₃₆ is nothing, with the proviso that one of R₅₁ to R₅₄ and Ar₃₅ to Ar₃₇ is a single bond linked to one of the linkers L₃₁ to L₃₄ in Formula D.

The compound of Formula D employed in the organic electroluminescent device of the present invention may be specifically selected from the compounds of Formulae D1 to D79:

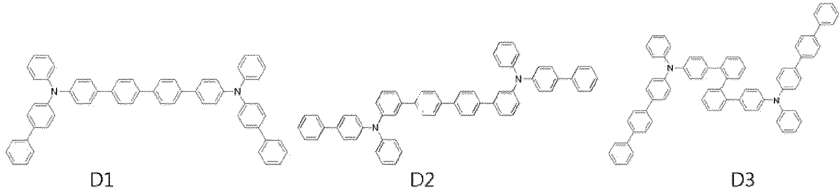

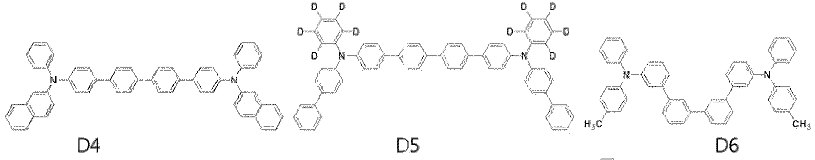

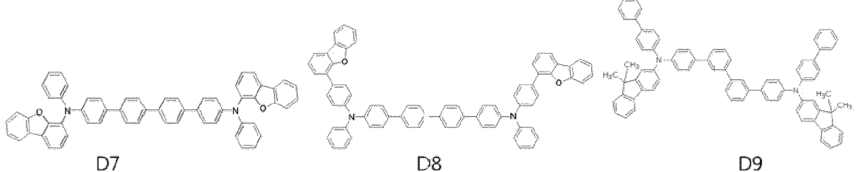

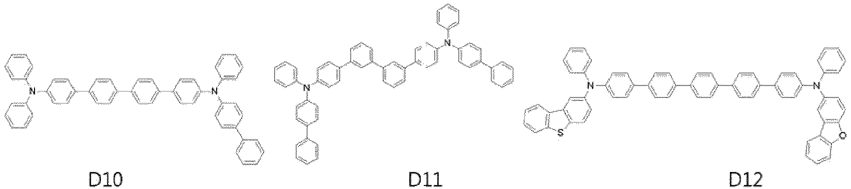

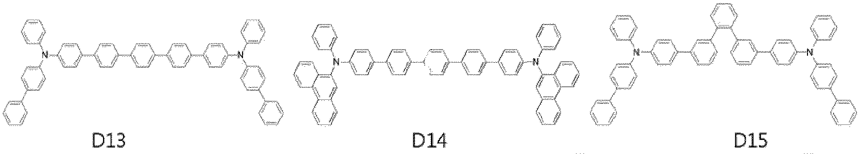

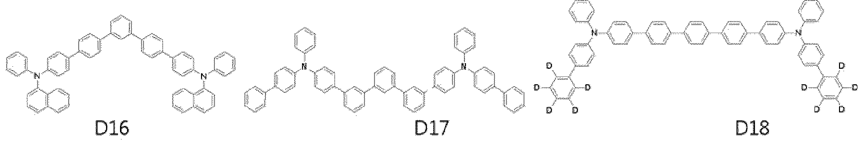

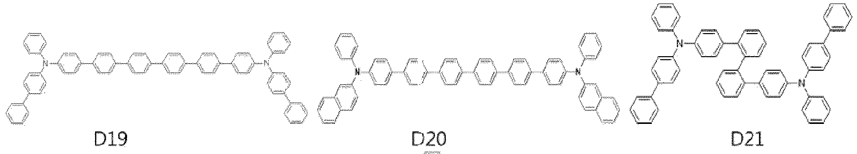

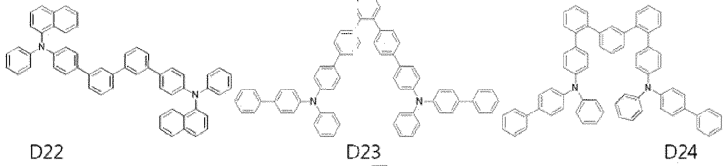

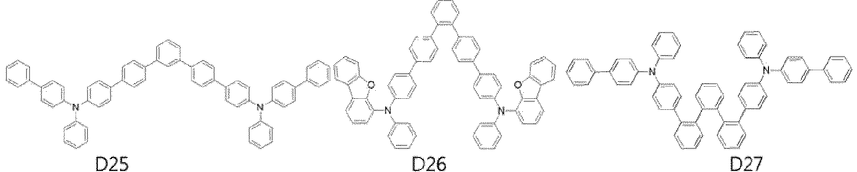

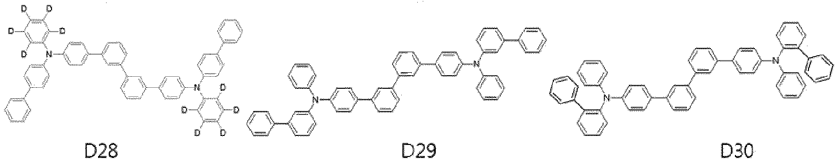

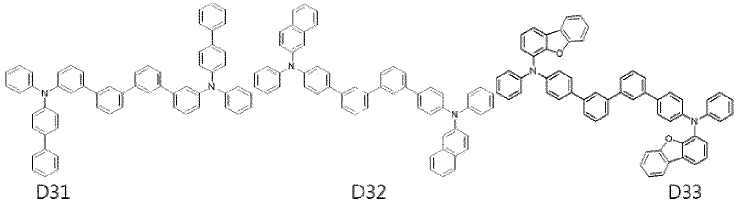

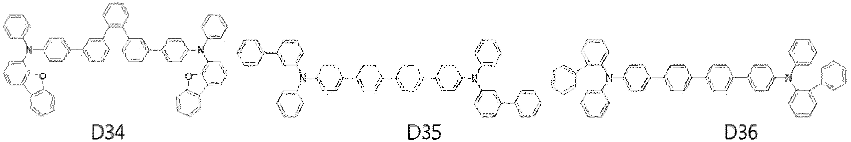

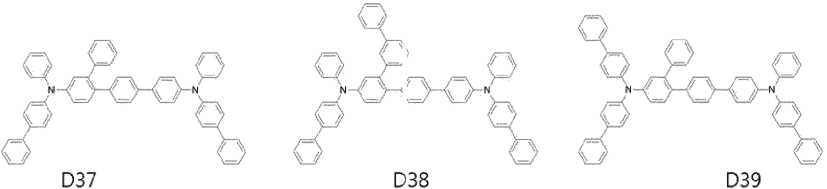

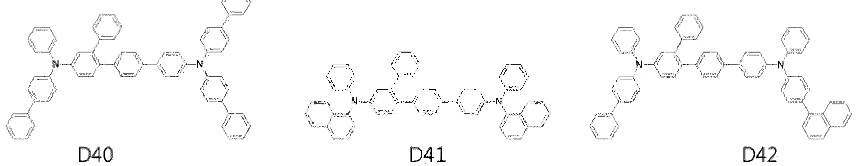

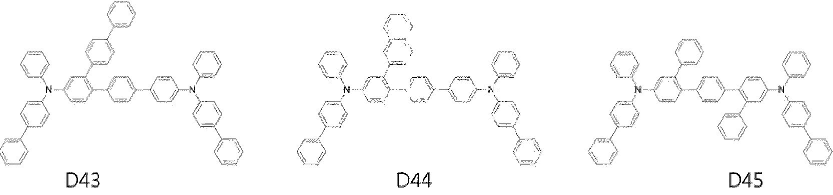

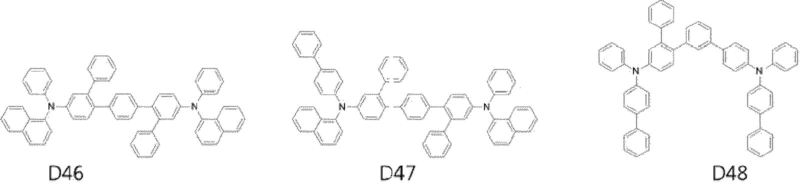

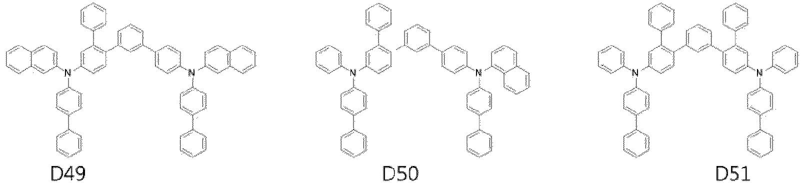

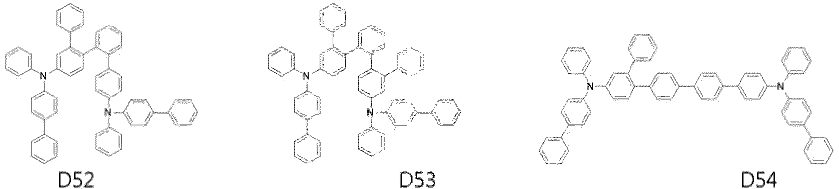

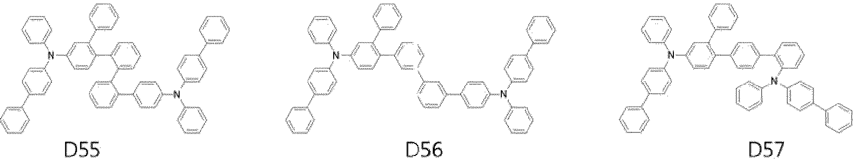

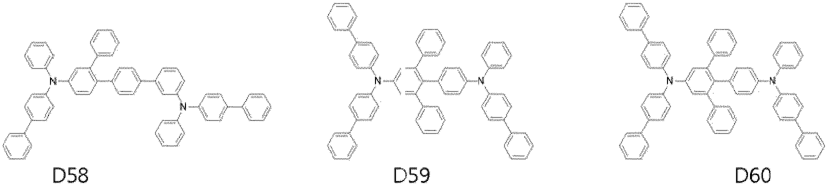

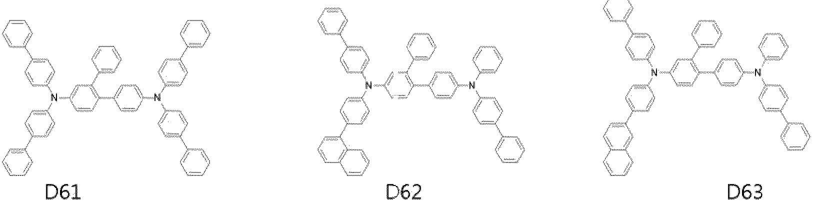

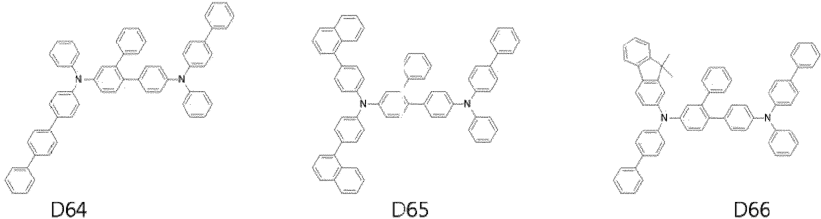

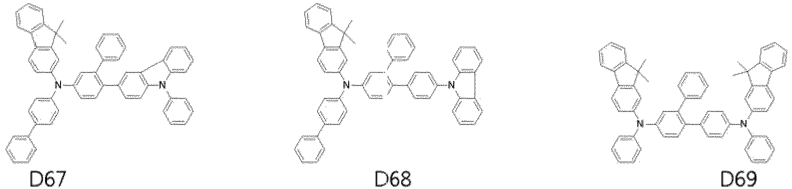

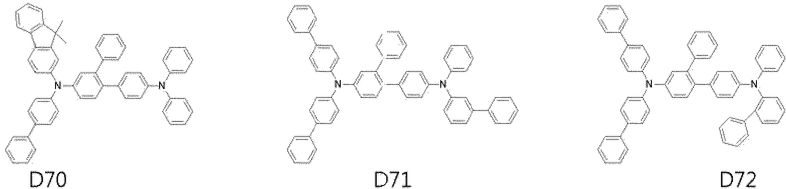

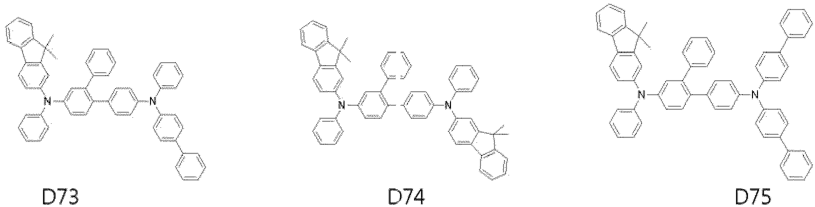

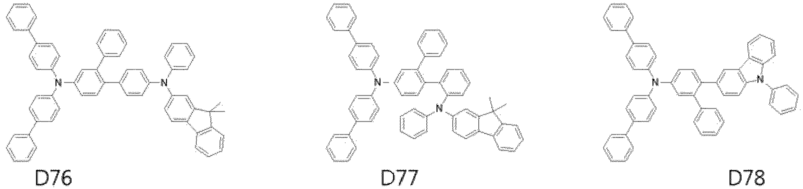

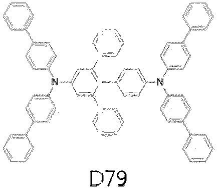

The compound of Formula D employed in the organic electroluminescent device of the present invention may be specifically selected from the compounds of Formulae D101 to D145:

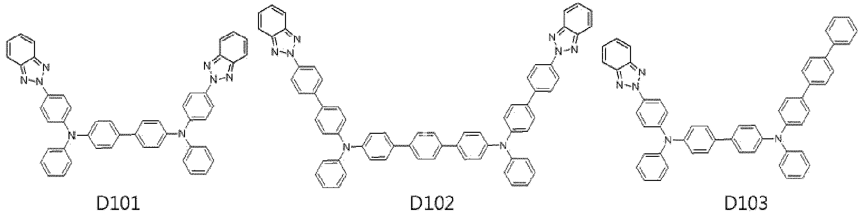

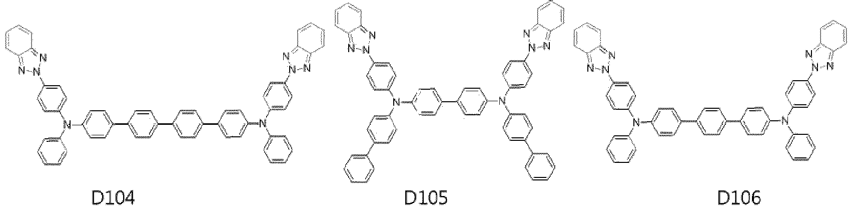

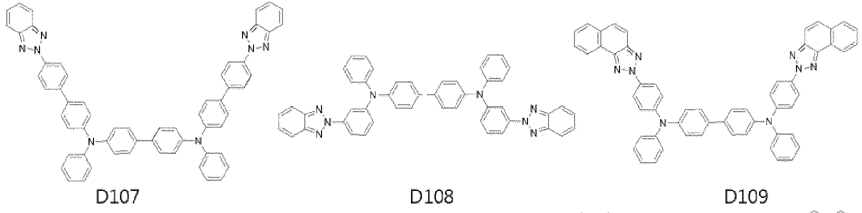

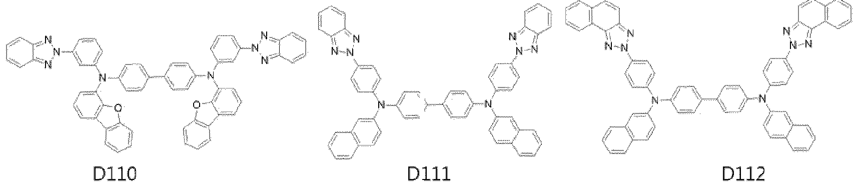

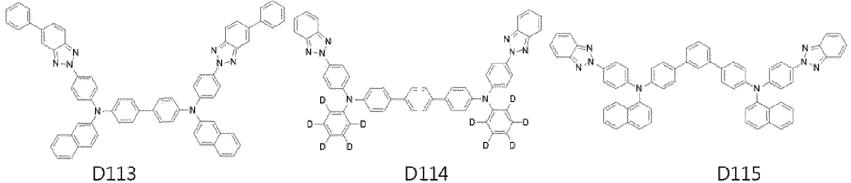

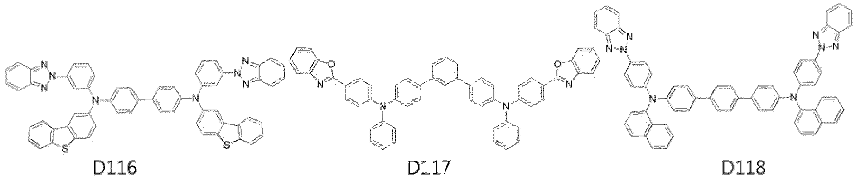

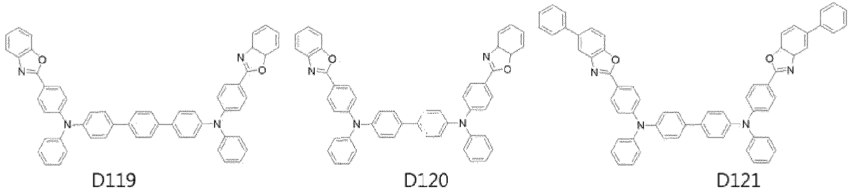

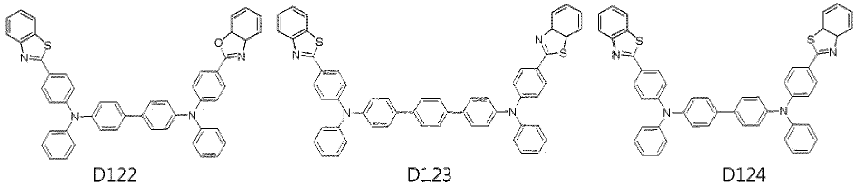

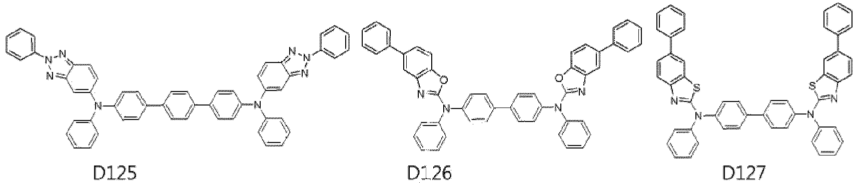

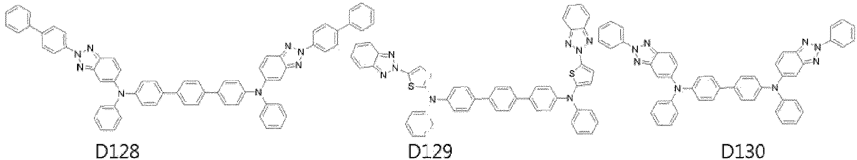

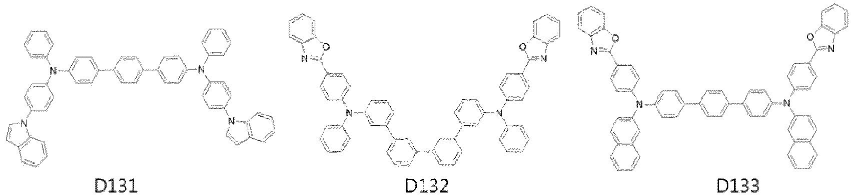

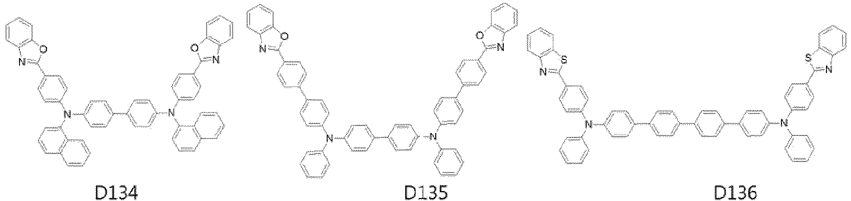

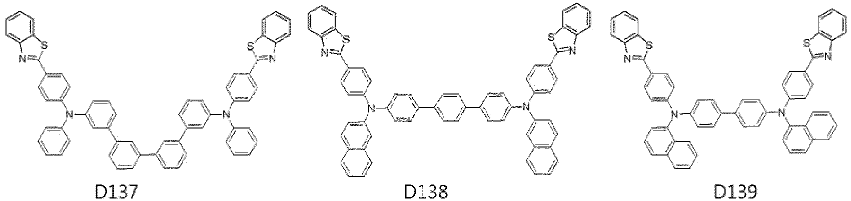

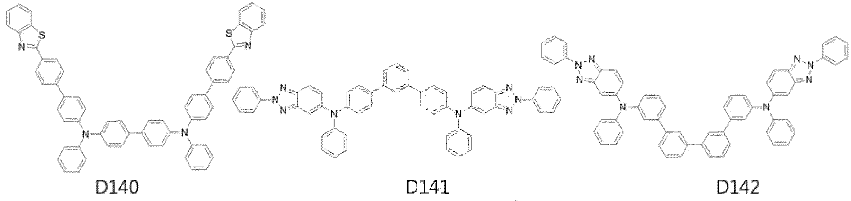

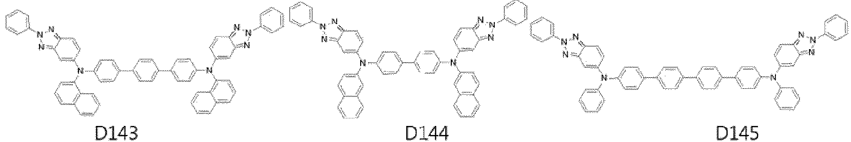

The organic electroluminescent device of the present invention may further include a hole transport layer and an electron blocking layer, each of which may include a compound represented by Formula F: 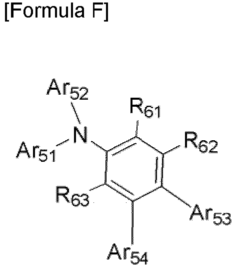 wherein R₆₁ to R₆₃ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, substituted or unsubstituted C₆-C₃₀ arylsilyl, substituted or unsubstituted C₁-C₃₀ alkylgermanium, substituted or unsubstituted C₁-C₃₀ arylgermanium, cyano, nitro, and halogen, and Ar₅₁ to Ar₅₄ are identical to or different from each other and are each independently substituted or unsubstituted C₆-C₄₀ aryl or substituted or unsubstituted C₂-C₃₀ heteroaryl.

The compound of Formula F employed in the organic electroluminescent device of the present invention may be specifically selected from the compounds of Formulae F1 to F33:

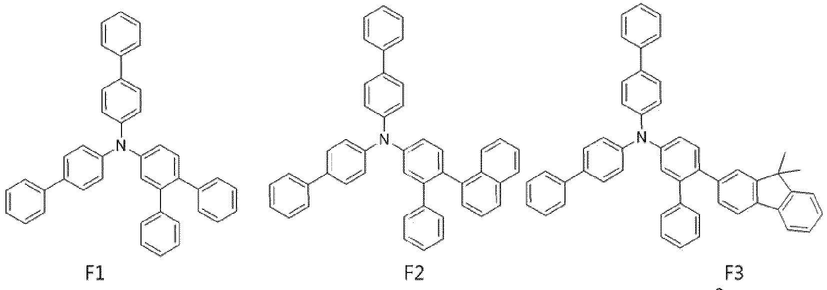

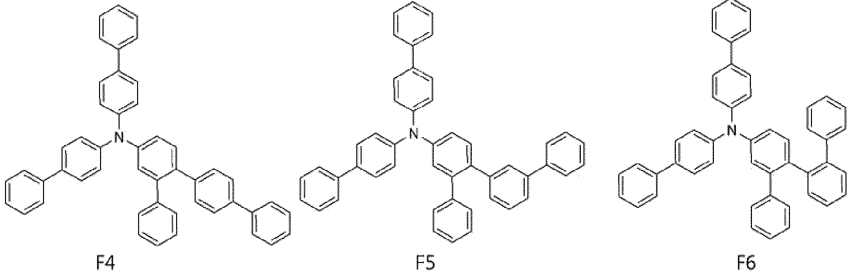

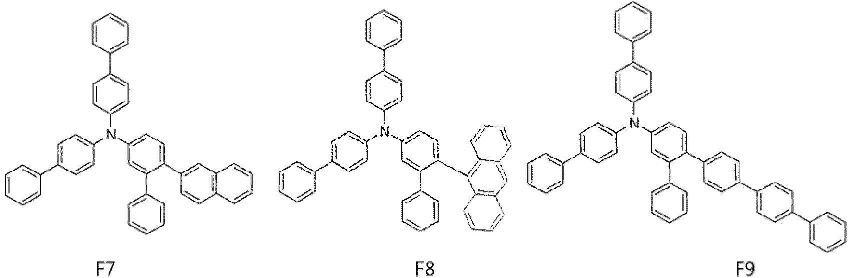

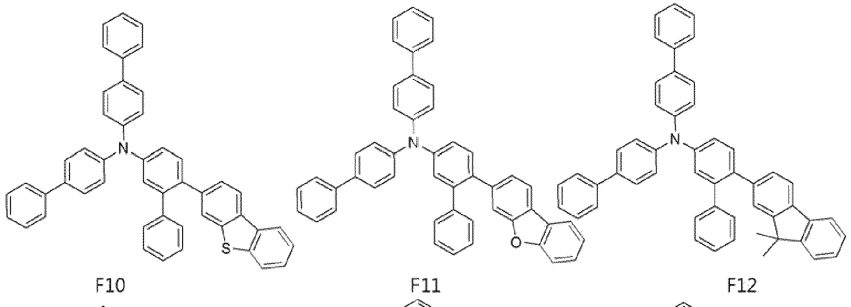

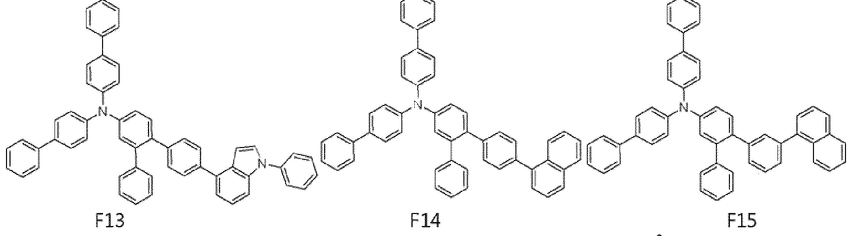

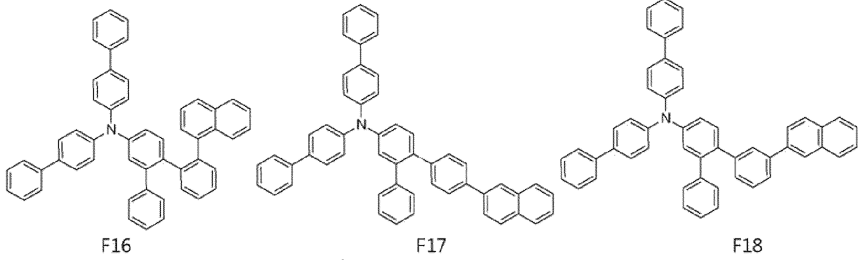

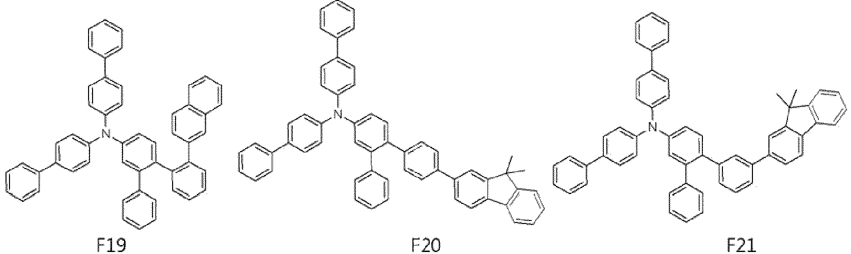

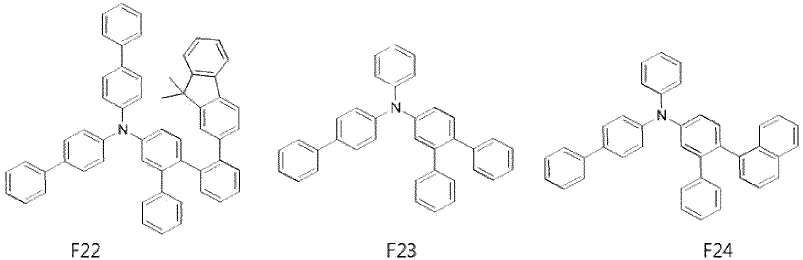

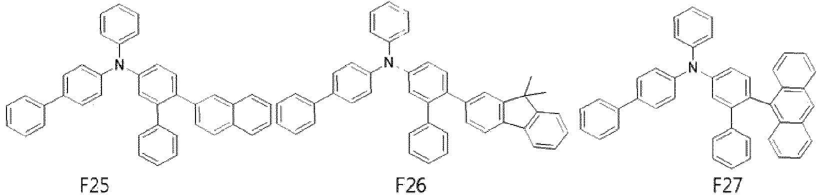

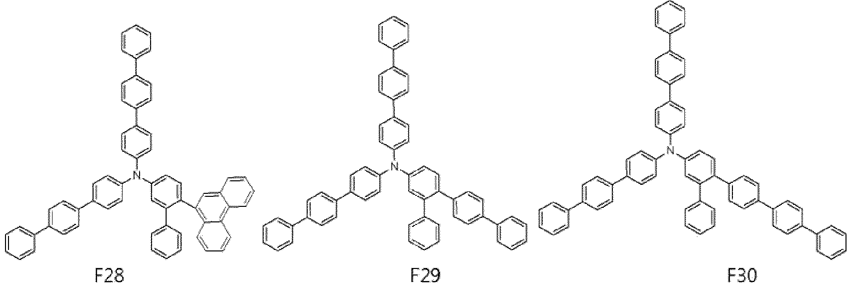

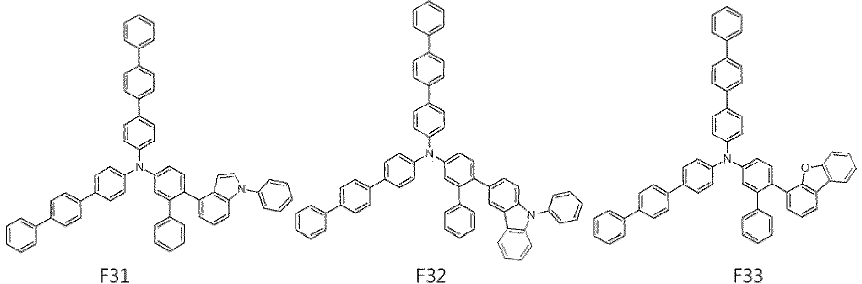

A specific structure of the organic electroluminescent device according to the present invention, a method for fabricating the device, and materials for the organic layers will be described below.

First, an anode material is coated on a substrate to form an anode. The substrate may be any of those used in general electroluminescent devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis(4-(phenyl-m-tolylamino)phenyl)biphenyl-4,4'-diamine (DNTPD).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially laminated on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, NTAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic electroluminescent device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic electroluminescent device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolate)aluminum (Alq3), TAZ, Balq, beryllium bis(benzoquinolin-10-olate (Bebq2), ADN, and oxadiazole derivatives such as PBD, BMD, and BND.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent, and then the mixture is formed into a thin film by a suitable method such as ink-jet printing, roll-to-roll coating, screen printing, spray coating, dip coating or spin coating.

The organic electroluminescent device of the present invention can be used in a display or lighting system selected from flat panel displays, flexible displays, monochromatic flat panel lighting systems, white flat panel lighting systems, flexible monochromatic lighting systems, and flexible white lighting systems.

Hereinafter, the present invention will be described in more detail with reference to preferred examples. However, it will be obvious to those skilled in the art that these examples are merely provided for illustration of the present invention, and should not be construed as limiting the scope of the present invention.

### Synthesis Example 1. Synthesis of Compound 1

### Synthesis Example 1-1. Synthesis of <Intermediate 1-a>

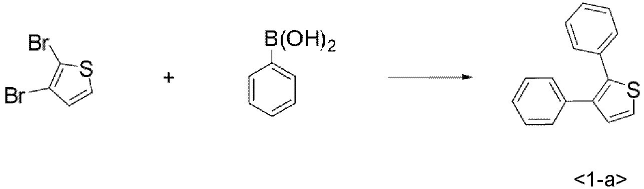

25 g (103 mmol) of 2,3-dibromothiophene, 30.2 g (248 mmol) of phenylboronic acid, 42.8 g (310 mmol) of potassium carbonate, 4.8 g (4 mmol) of tetrakis(triphenylphosphine)palladium, 60 mL of water, 130 mL of toluene and 130 mL of 1,4-dioxane were stirred under reflux in a 500 mL reactor for 12 hours. After completion of the reaction, the reaction product was layer-separated and the organic layer was concentrated under reduced pressure. The residue was separated by chromatography to obtain 22.4 g of <Intermediate 1-a>. (yield 85.1 %)

### Synthesis Example 1-2. Synthesis of <Intermediate 1-b>

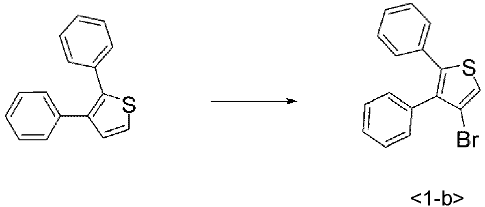

24 g (102 mmol) of <Intermediate 1-a> and 240 mL of chloroform were added to a 500 mL reactor, followed by stirring. The reaction product was cooled to 0 °C, a dilution of 15.5 g (102 mmol) of bromine in 50 mL of chloroform was added dropwise, followed by stirring at room temperature for 4 hours. After completion of the reaction, an aqueous sodium thiosulfate solution was added thereto, followed by stirring and extraction with ethenyl acetate and H₂O. The organic layer was concentrated under reduced pressure and separated by chromatography to obtain 30 g of <Intermediate 1-b>. (Yield: 88%)

### Synthesis Example 1-3. Synthesis of <Intermediate 1-c>

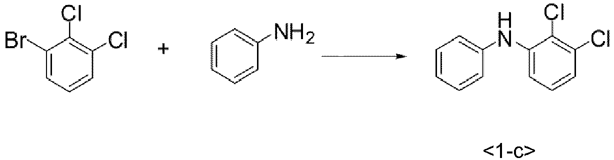

4.5 g (16 mmol) of 1-bromo-2,3-dichlorobenzene, 5.8 g (16 mmol) of aniline, 0.1 g (1 mmol) of palladium acetate, 3 g (32 mmol) of sodium tert-butoxide, 0.2 g (1 mmol) of bis(diphenylphosphino)-1,1'-binaphthyl, and 45 mL of toluene were stirred under reflex in a 100 mL reactor for 24 hours. After completion of the reaction, the filtrate was concentrated and separated by chromatography to obtain 5.2 g of <Intermediate 1-c>. (yield 82%)

### Synthesis Example 1-4. Synthesis of <Intermediate 1-d>

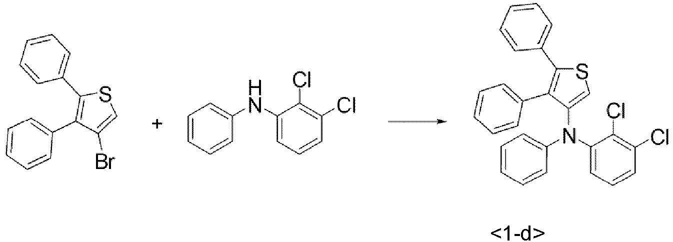

20 g (98 mmol) of <Intermediate 1-b>, 18.4 g (98 mmol) of <Intermediate 1-c>, 0.5 g (2 mmol) of palladium acetate, 18.9 g (196 mmol) of sodium tert-butoxide, 0.8 g (4 mmol) of tri-tert-butylphosphine, and 200 mL of toluene were stirred under reflux in a 500 mL reactor for 5 hours. After completion of the reaction, the filtrate was concentrated and separated by chromatography to obtain 22 g of <Intermediate 1-d>. (yield 75%)

### Synthesis Example 1-5. Synthesis of <Intermediate 1-e>

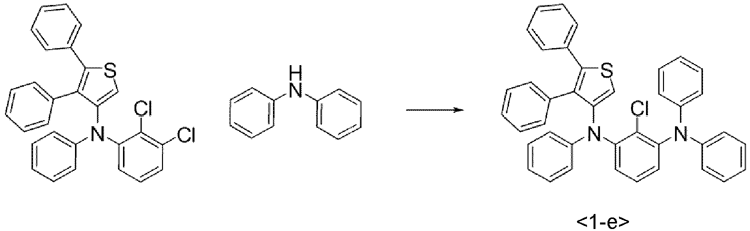

18.5 g of <Intermediate 1-e> was obtained in the same manner as in Synthesis Example 1-4 except that <Intermediate 1-d> and diphenylamine were used instead of <Intermediate 1-b> and <Intermediate 1-c>. (yield 74.1%)

### Synthesis Example 1-6. Synthesis of <Compound 1>

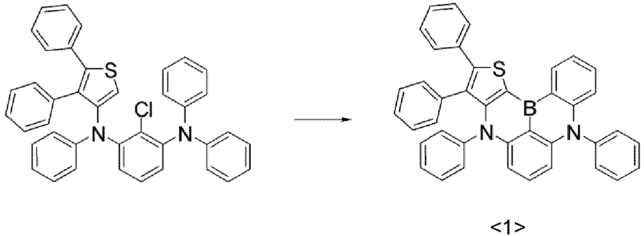

18.5 g (23 mmol) of <Intermediate 1-e> and 190 mL of tert-butylbenzene were added to a 300 mL reactor. 42.5 mL (115 mmol) of tert-butyllithium was added dropwise thereto at -78 °C. After dropwise addition, the resulting product was stirred at 60 °C for 3 hours. Then, the pentane was removed by purging with nitrogen. 11.3 g (46 mmol) of boron tribromide was added dropwise thereto at -78 °C. After dropwise addition, the mixture was stirred at room temperature for 2 hours, and 5.9 g (46 mmol) of N,N-diisopropylethylamine was added dropwise at 0 °C. After dropwise addition, the mixture was stirred at 120 °C for 2 hours. After completion of the reaction, an aqueous solution of sodium acetate was added at room temperature and stirred. After extraction with ethyl acetate, the organic layer was concentrated and separated by column chromatography to obtain 3.4 g of <Compound 1>. (yield 15.7%)
MS (MALDI-TOF) : m/z 578.20 [M⁺]

### Synthesis Example 2. Synthesis of Compound 19

### Synthesis Example 2-1. Synthesis of <Intermediate 2-a>

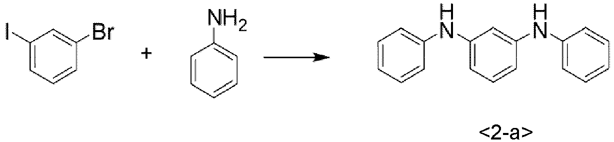

50 g (177 mmol) of 1-bromo-3-iodobenzene, 36.2 g (389 mmol) of aniline, 1.6 g (7 mmol) of palladium acetate, 51 g (530 mmol) of sodium tert-butoxide, 4.4 g (7 mmol) of bis(diphenylphosphino)-1,1'-binaphthyl, and 500 mL of toluene were stirred under reflux in a 1L reactor for 24 hours. After completion of the reaction, the resulting product was filtered and the filtrate was concentrated and separated by chromatography to obtain 42.5 g of <Intermediate 2-a>. (yield 50%)

### Synthesis Example 2-2. Synthesis of <Intermediate 2-b>

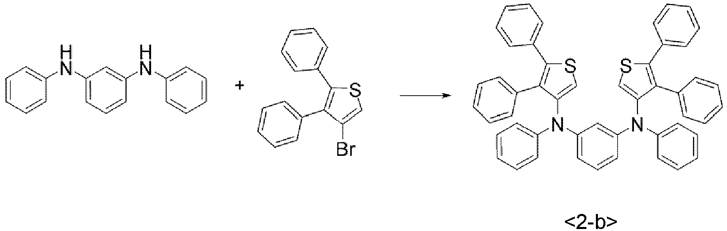

11 g (42 mmol) of <Intermediate 2-a>, 20 g (101 mmol) of <Intermediate 1-b>, 1 g (2 mmol) of palladium acetate, 12.2 g (127 mmol) of sodium tert-butoxide, 0.7 g (3 mmol) of tri-tert-butylphosphine, and 150 mL of toluene were stirred under reflux in a 250 mL reactor for 5 hours. After completion of the reaction, the resulting product was filtered and the filtrate was concentrated and separated by chromatography to obtain 11 g of <Intermediate 2-b>. (yield 65%)

### Synthesis Example 2-3. Synthesis of <Compound 19>

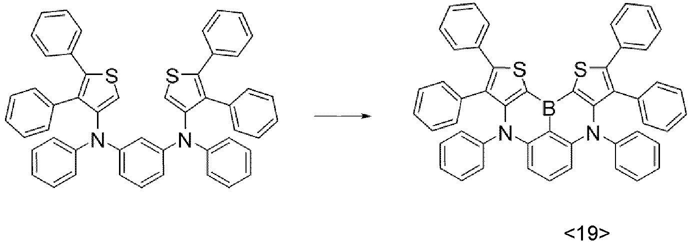

2.7 g of <Compound 19> was obtained in the same manner as in Synthesis Example 1-6 except that <Intermediate 2-b> was used instead of <Intermediate 1-e>. (yield 14.7%)
MS (MALDI-TOF) : m/z 736.22 [M⁺]

### Synthesis Example 3. Synthesis of Formula 97

### Synthesis Example 3-1. Synthesis of <Intermediate 3-a>

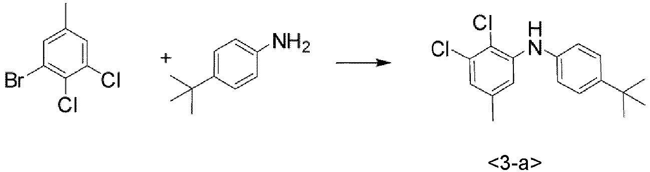

35.6 g of <Intermediate 3-a> was obtained in the same manner as in Synthesis Example 1-3 except that 1-bromo-2,3-dichloro-5-methylbenzene and 4-tert-butylaniline were used instead of 1-bromo-4-iodobenzene and aniline. (yield 71.2%)

### Synthesis Example 3-2. Synthesis of <Intermediate 3-b>

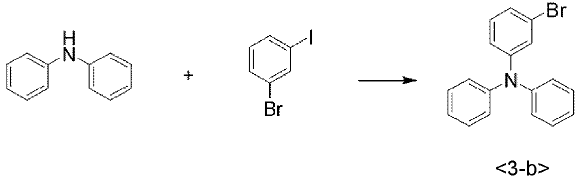

60.0 g (355 mmol) of diphenylamine, 100.3 g (355 mmol) of 1-bromo-3-iodobenzene, 0.8 g (4 mmol) of palladium acetate, 2 g (4 mmol) of Xantphos, 68.2 g (709 mmol) of sodium tert-butoxide and 700 mL of toluene were stirred under reflux in a 2L reactor for 2 hours. After completion of the reaction, the resulting product was filtered at room temperature and the filtrate was concentrated under reduced pressure and separated by chromatography to obtain 97 g of <Intermediate 3-b>. (yield 91.2%)

### Synthesis Example 3-3. Synthesis of <Intermediate 3-c>

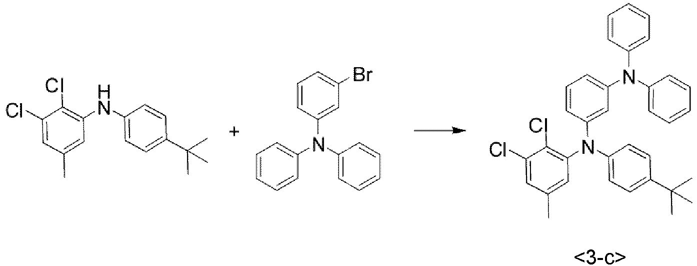

31 g of <Intermediate 3-c> was obtained in the same manner as in Synthesis Example 1-4 except that <Intermediate 3-a> and <Intermediate 3-b> were used instead of <Intermediate 1-c> and <Intermediate 1-b> (yield 77.7%)

### Synthesis Example 3-4. Synthesis of <Intermediate 3-d>

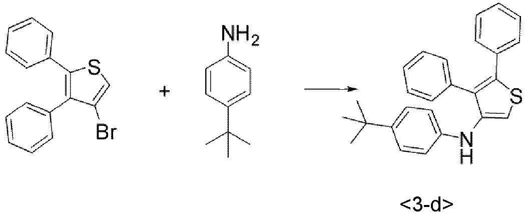

31.6 g of <Intermediate 3-d> was obtained in the same manner as in Synthesis Example 1-3 except that <Intermediate 1-b> and 4-tert-butylaniline were used instead of <Intermediate 1-b> and 4-tert-butylaniline. (yield 68.2)

### Synthesis Example 3-5. Synthesis of <Intermediate 3-e>

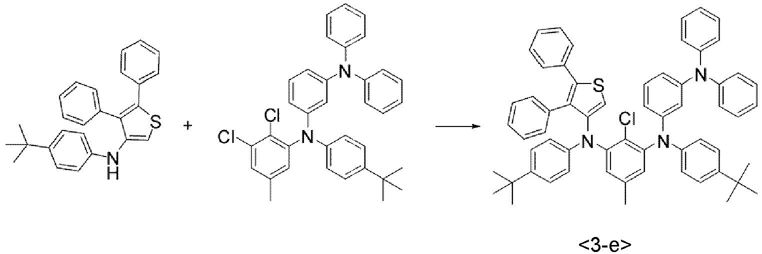

21 g of <Intermediate 3-e> was obtained in the same manner as in Synthesis Example 1-4 except that <Intermediate 3-c> and <Intermediate 3-d> were used instead of <Intermediate 1-c> and <Intermediate 1-b>. (yield 67.7)

### Synthesis Example 3-6. Synthesis of <Compound 97>

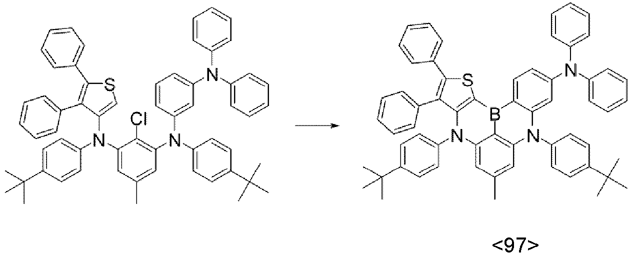

2.4 of <Compound 97> was obtained in the same manner as in Synthesis Example 1-6 except that <Intermediate 3-e> was used instead of <Intermediate 1-e>. (yield 15.4%)
MS (MALDI-TOF) : m/z 871.41 [M⁺]

### Example 1 to 10 : Fabrication of organic light-emitting devices

ITO glass was patterned such that a light-emitting area of the ITO glass was adjusted to 2 mm × 2 mm and was then washed. The ITO glass was mounted in a vacuum chamber, a base pressure was set to 1,33 x 10⁻⁵ Pa (1 × 10⁻⁷ torr), and DNTPD (700 Å) and [Formula H] (250 Å) were sequentially deposited on ITO. Then, a mixture of the host [BH1] described below and the compound of the present invention (3 wt%) was deposited to a thickness of 250Å to form a light-emitting layer. Then, a mixture (1:1) of [Formula E-1] and [Formula E-2] was deposited thereon to a thickness of 300Å to form an electron transport layer, [Formula E-1] was deposited thereon to a thickness of 5Å to form an electron injection layer, and Al was deposited thereon to a thickness of 1,000Å. As a result, an organic light-emitting device was fabricated. The luminous characteristics of the organic light-emitting device were measured at 0.4 mA.

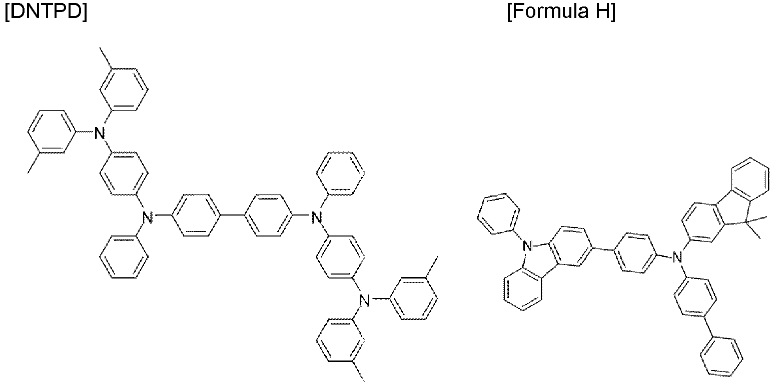

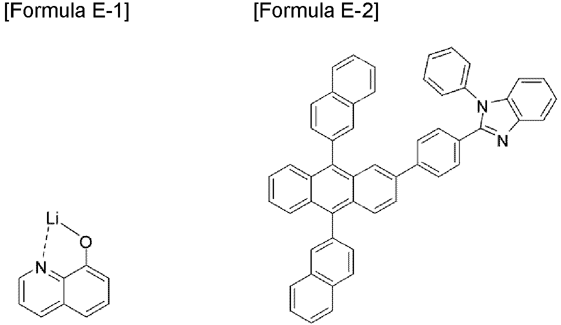

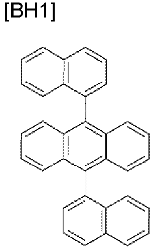

### Comparative Examples 1 to 3

Organic light-emitting devices were fabricated in the same manner as in Examples above, except that [BD1] to [BD3] were used instead of the compound used in Example 1. The luminous characteristics of the organic light-emitting device were measured at 0.4 mA. The structures of [BD1] to [BD3] are as follows.

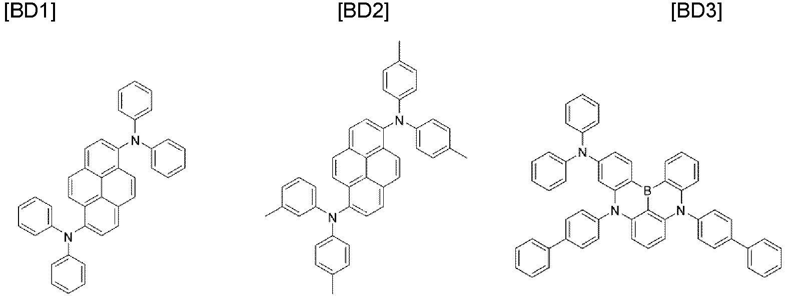

The voltage, luminance, color coordinates and lifespan of the organic light-emitting devices manufactured according to Examples 1 to 10 and Comparative Examples 1 to 3 were measured and the results are shown in Table 1 below.

**[Table 1]**

| Item | Dopant | Current density (mA/cm²) | Voltage (V) | External quantum efficiency (%) | T90 (h r) |
|---|---|---|---|---|---|
| Example 1 | 1 | 10 | 3.8 | 8.7 | 185 |
| Example 2 | 19 | 10 | 3.7 | 8.8 | 198 |
| Example 3 | 97 | 10 | 3.9 | 8.5 | 187 |
| Example 4 | 4 | 10 | 3.7 | 8.6 | 178 |
| Example 5 | 7 | 10 | 3.8 | 8.7 | 180 |
| Example 6 | 10 | 10 | 3.8 | 8.8 | 185 |
| Example 7 | 31 | 10 | 3.7 | 8.5 | 165 |
| Example 8 | 34 | 10 | 3.8 | 8.6 | 180 |
| Example 9 | 40 | 10 | 3.9 | 8.6 | 185 |
| Example 10 | 46 | 10 | 3.7 | 8.7 | 170 |
| Comparative Example 1 | BD1 | 10 | 4.17 | 7.5 | 142 |
| Comparative Example 2 | BD2 | 10 | 4.22 | 7.1 | 137 |
| Comparative Example 3 | BD3 | 10 | 4.15 | 5.8 | 88 |

As can be seen from Examples 1 to 10, the organic light-emitting device containing the boron compound according to the present invention exhibits high external quantum efficiency and significantly improved lifespan, compared to organic light-emitting devices using Comparative Examples 1 to 3.

### Example 11 to 18 : Fabrication of organic light-emitting devices

ITO glass was patterned such that a light-emitting area of the ITO glass was adjusted to 2 mm × 2 mm and was then washed. The ITO glass was mounted in a vacuum chamber, a base pressure was set to 1,33 × 10⁻⁵ Pa (1 × 10⁻⁷ torr), and 2-TNATA (4,4',4"-tris[2-naphthyl(phenyl)amino]triphenyl amine) (700 Å) and a hole transport layer (600 Å) were sequentially deposited on ITO. Then, a mixture of the host described in [Table 2] and the compound of the present invention (3 wt%) was deposited to a thickness of 200Å to form a light-emitting layer. Then, [Formula E-2] was deposited thereon to a thickness of 300Å to form an electron transport layer, [Formula E-1] was deposited thereon to a thickness of 10Å to form an electron injection layer, MgAg was deposited thereon to a thickness of 120Å and a capping layer was then deposited thereon to a thickness of 600Å. As a result, an organic light-emitting device was fabricated. The luminous characteristics of the organic light-emitting device were measured at 0.4 mA.

### Comparative Examples 4 and 5

Organic light-emitting devices were fabricated in the same manner as in Examples 11 to 18, except that Alq3 was used as a capping layer. The luminous characteristics of the organic light-emitting device were measured at 10 mA. The structure of [Alq3] is as follows.

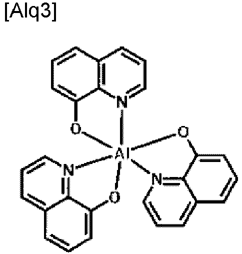

**[Table 2]**

| Item | Hole transport layer | Host | Dopant | Capping layer | Current density (mA/cm²) | Voltage (V) | External quantum efficiency (%) |
|---|---|---|---|---|---|---|---|
| Example 11 | D31 | BH1 | 1 | D103 | 10 | 3.95 | 16.5 |
| Example 12 | D37 | C20 | 4 | D109 | 10 | 3.85 | 18.4 |
| Example 13 | H | C38 | 7 | D112 | 10 | 4.02 | 17.5 |
| Example 14 | F15 | C38 | 19 | D113 | 10 | 3.92 | 18.4 |
| Example 15 | H | BH1 | 31 | D103 | 10 | 4.05 | 17.5 |
| Example 16 | D31 | BH1 | BD1 | D108 | 10 | 4.06 | 16.6 |
| Example 17 | F15 | C38 | BD2 | D106 | 10 | 3.92 | 16.8 |
| Example 18 | F15 | C38 | 40 | D107 | 10 | 3.83 | 18.9 |
| Comparative Example 4 | H | BH1 | BD1 | Alq3 | 10 | 4.1 | 14.3 |
| Comparative Example 5 | H | BH1 | BD2 | Alq3 | 10 | 4.3 | 13.7 |

As can be seen from Examples 11 to 18, the organic light-emitting device containing the compound according to the present invention, in particular, the organic light-emitting device according to the present invention exhibits high external quantum efficiency and significantly improved lifespan, compared to a device using the [Alq3] compound as a capping layer.

### Industrial Applicability

The polycyclic aromatic derivative of the present invention can be employed in an organic layer of an organic electroluminescent device to achieve high efficiency and long lifetime of the device. Due to these advantages, the organic electroluminescent device can find useful industrial application in various displays and lighting systems, including flat panel displays, flexible displays, monochromatic flat panel lighting systems, white flat panel lighting systems, flexible monochromatic lighting systems, and flexible white lighting systems.

## Claims

1. An organic light-emitting compound represented by the following [Formula A-1], 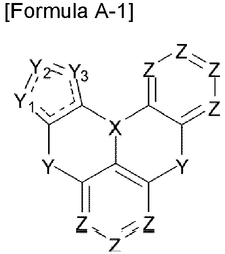 wherein
Y₁ and Y₁ to Y₃ are each independently selected from N-R₁, CR₂R₃, O, S, Se and SiR₄R₅, with the proviso that Y's, and Y₁'s to Y₃'s are identical to or different from each other;
dotted lines represent a single bond or a double bond according to the definition of Y₁ to Y₃;
X is selected from B, P, and P=O;
R₁ to R₅ are identical to or different from each other and are each independently selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, and a halogen group, and
Z is CR or N, wherein R is selected from hydrogen, deuterium, a substituted or unsubstituted C1-C30 alkyl group, a substituted or unsubstituted C6-C50 aryl group, a substituted or unsubstituted C3-C30 cycloalkyl group, a substituted or unsubstituted C2-C50 heteroaryl group, a substituted or unsubstituted C1-C30 alkoxy group, a substituted or unsubstituted C6-C30 aryloxy group, a substituted or unsubstituted C1-C30 alkylthioxy group, a substituted or unsubstituted C5-C30 arylthioxy group, a substituted or unsubstituted C1-C30 alkylamine group, a substituted or unsubstituted C5-C30 arylamine group, a substituted or unsubstituted C1-C30 alkylsilyl group, a substituted or unsubstituted C5-C30 arylsilyl group, a nitro group, a cyano group, and a halogen (with the proviso that Z's and R's are identical to or different from each other),
wherein R's may be bonded to each other or may be linked to an adjacent substituent to form an alicyclic or aromatic monocyclic or polycyclic ring, and the carbon atom of the formed alicyclic or aromatic monocyclic or polycyclic ring may be substituted with at least one heteroatom selected from N, S and O.

2. The organic light-emitting compound according to claim 1, wherein [Formula A-1] is selected from [Compound 1] to [Compound 116]:

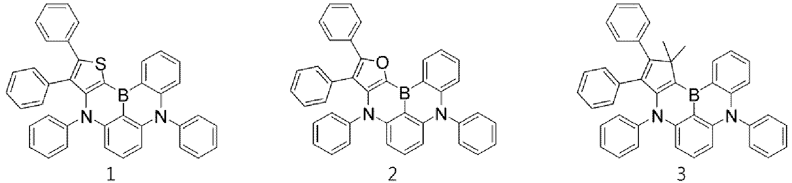

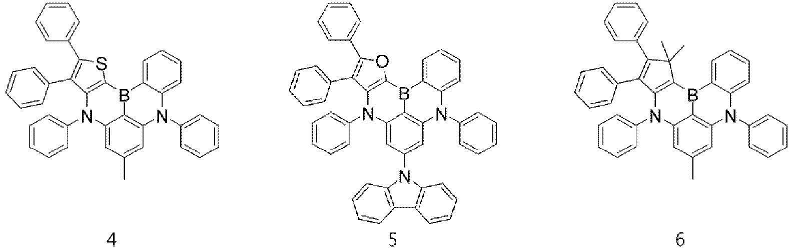

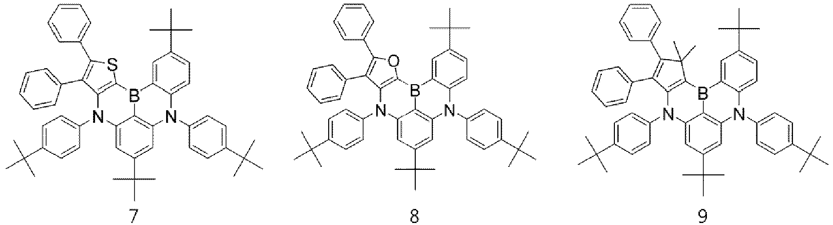

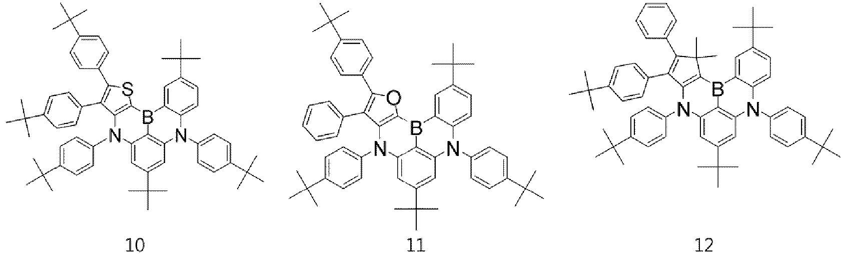

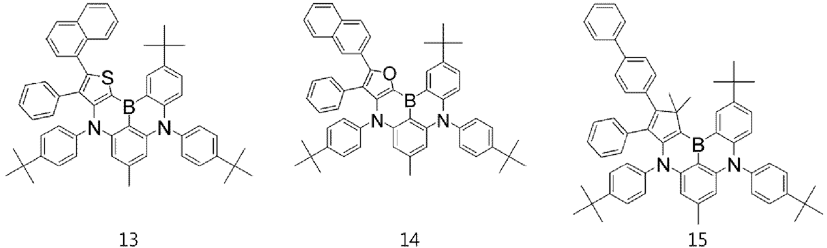

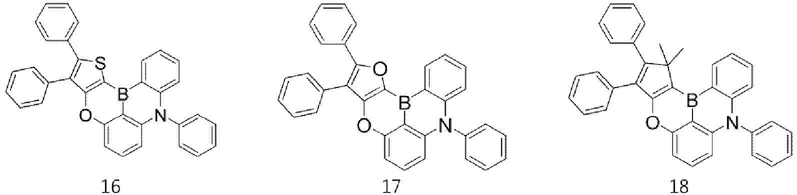

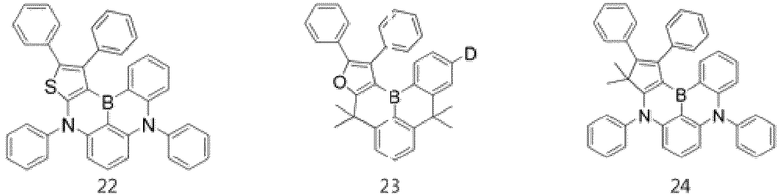

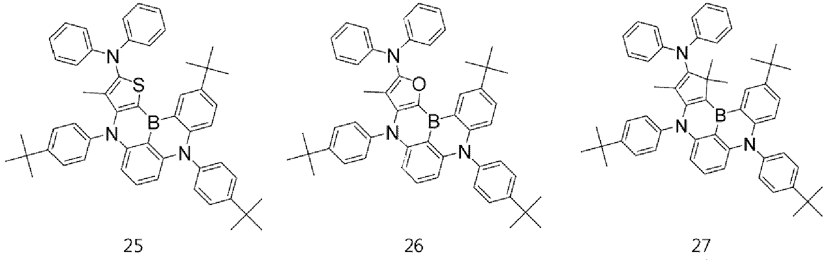

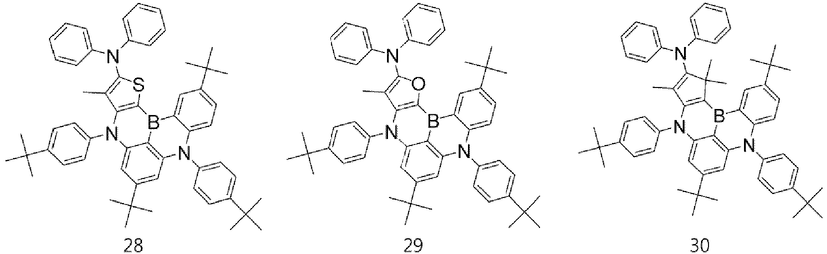

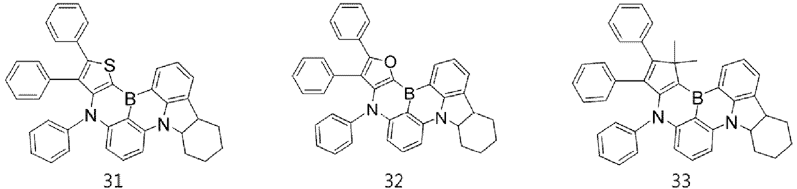

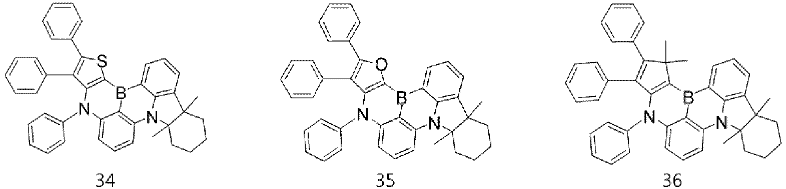

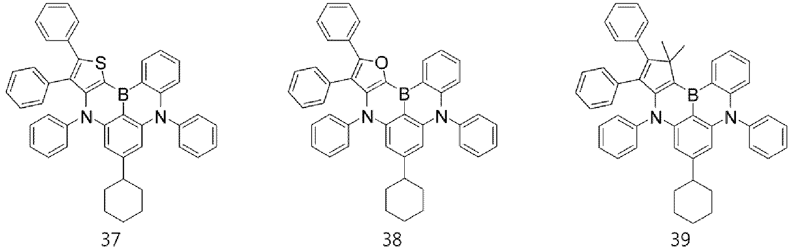

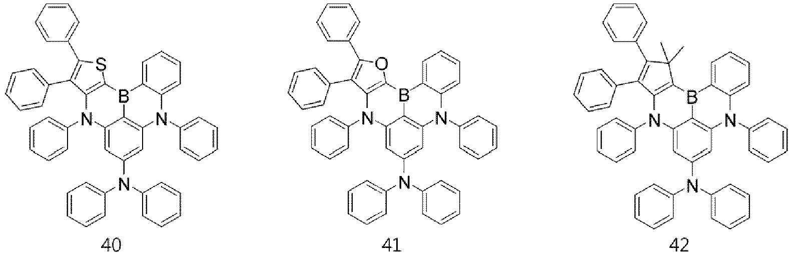

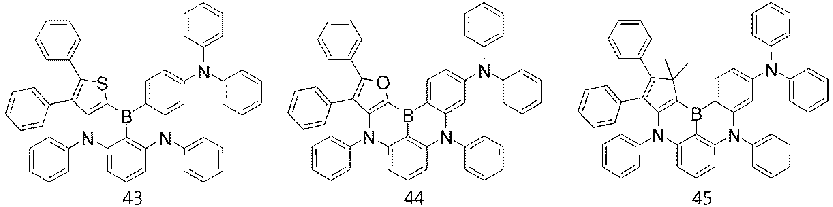

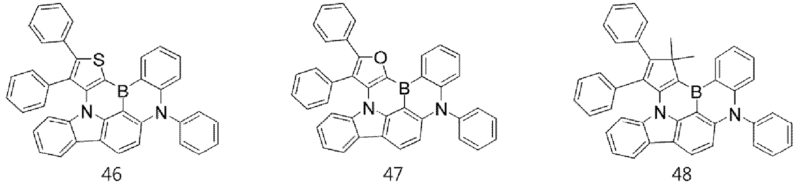

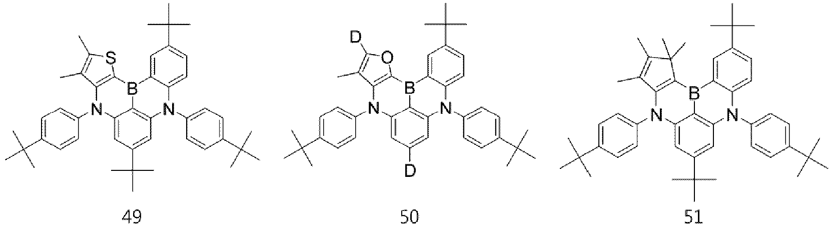

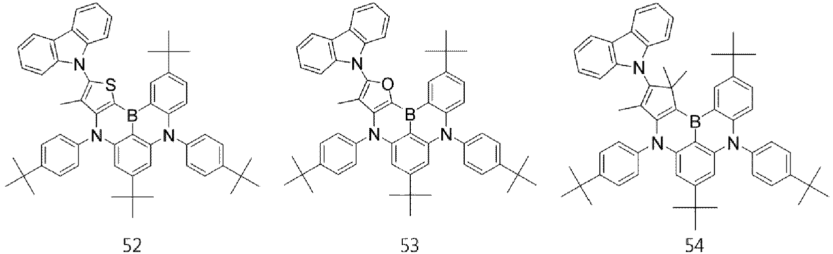

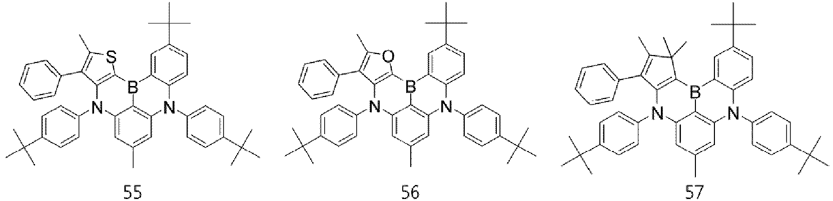

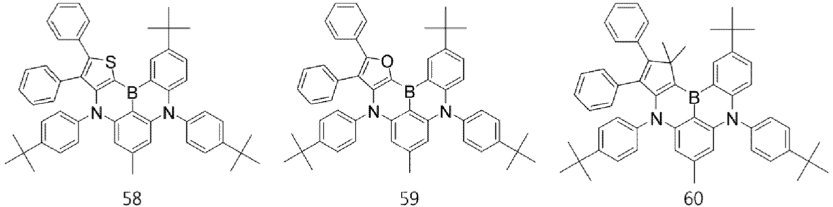

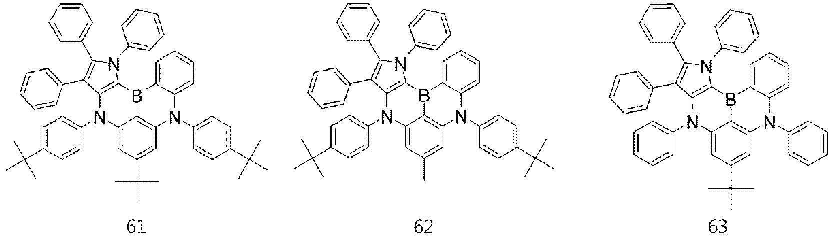

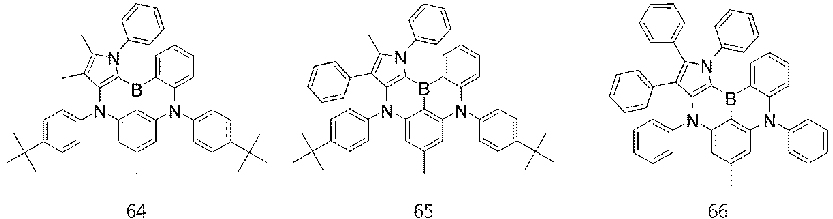

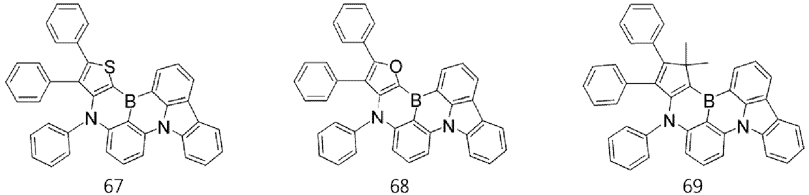

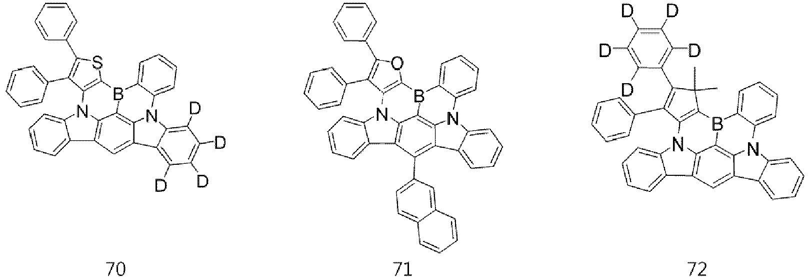

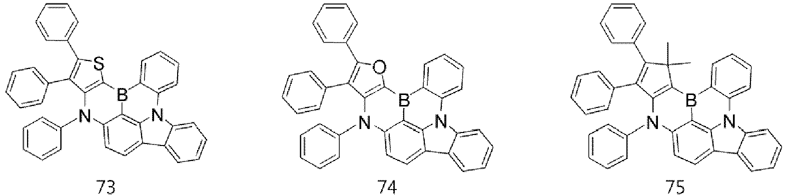

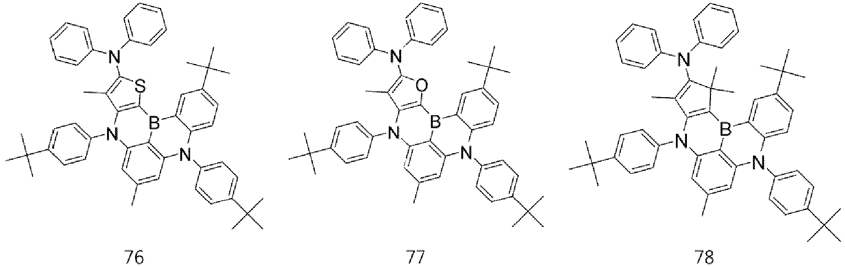

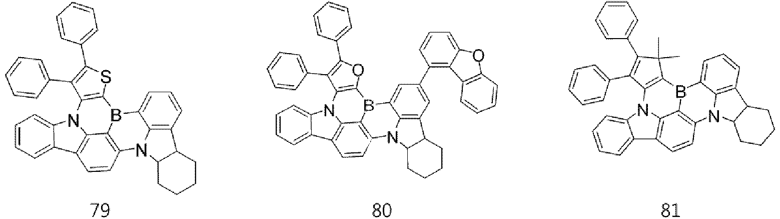

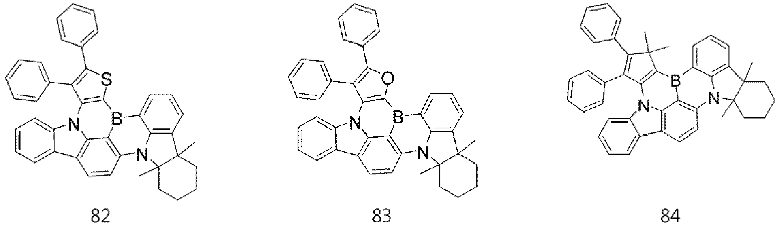

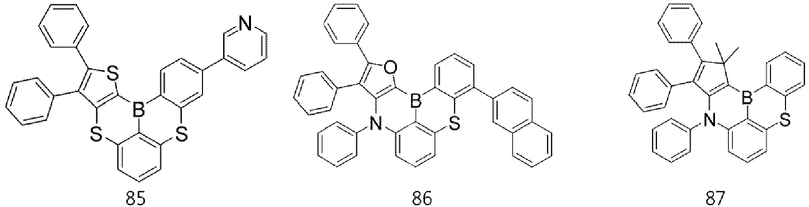

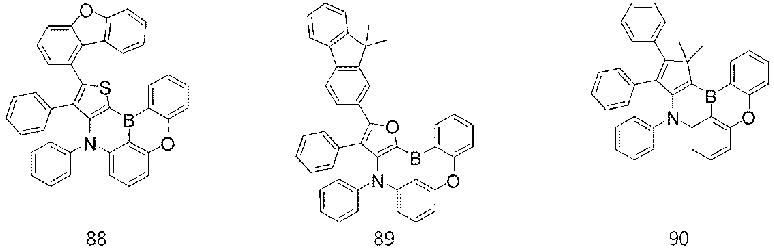

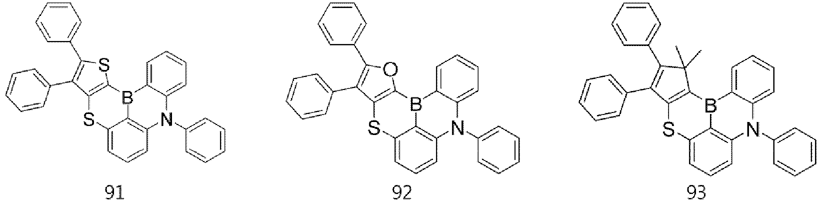

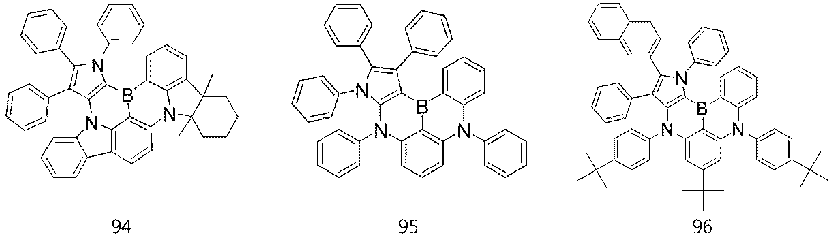

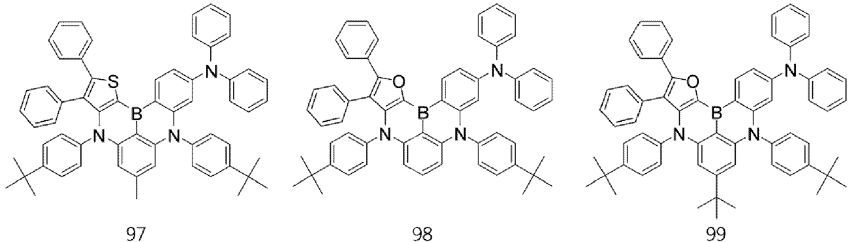

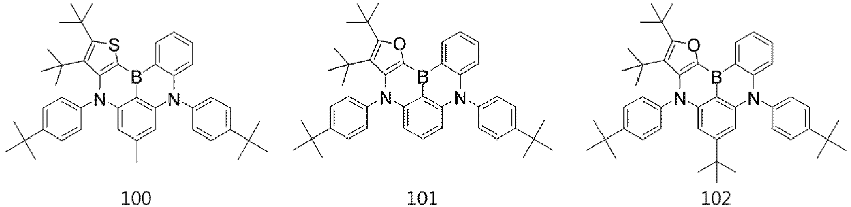

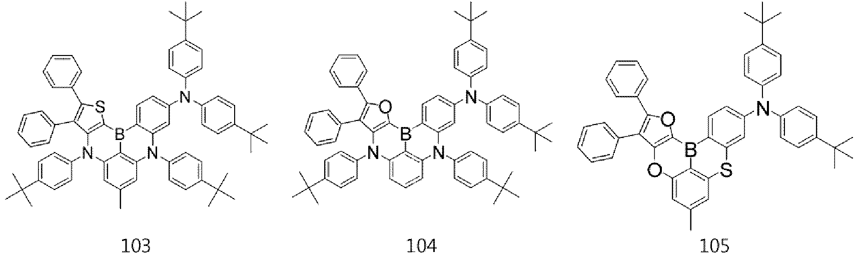

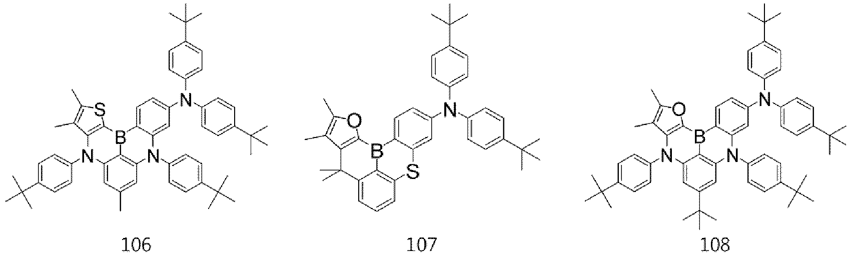

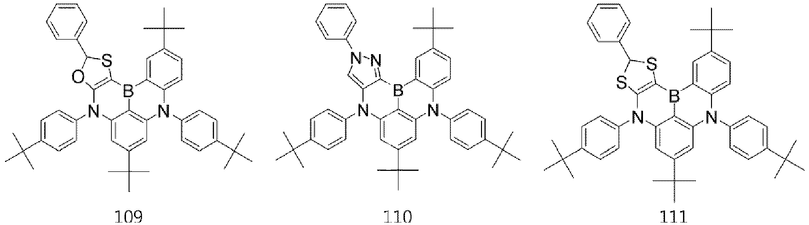

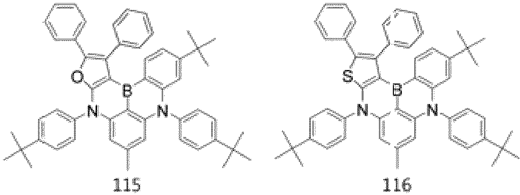

3. An organic light-emitting device comprising:
a first electrode;
a second electrode facing the first electrode; and
an organic layer interposed between the first electrode and the second electrode,
wherein the organic layer comprises at least one of the compounds represented by [Formula A-1] according to claim 1.

4. The organic light-emitting device according to claim 3, wherein the organic layer comprises at least one of an electron injection layer, an electron transport layer, a hole injection layer, a hole transport layer, an electron blocking layer, a hole blocking layer, and a light-emitting layer,
wherein at least one of the layers comprises the organic light-emitting compound represented by [Formula A-1].

5. The organic light-emitting device according to claim 3, wherein the organic layer interposed between the first electrode and the second electrode comprises a light-emitting layer, the light-emitting layer comprises a host and a dopant, and the compound represented by [Formula A-1] is used as a dopant.

6. The organic electroluminescent device according to claim 5, wherein the light emitting layer comprises, as a host compound, an anthracene derivative represented by Formula C: 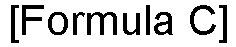 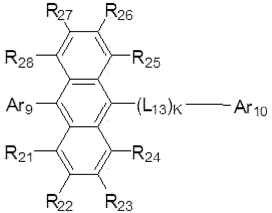 wherein R₂₁ to R₂₈ are identical to or different from each other and are as defined for R₁ to R₁₃ in Formula A-1 or A-2, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L₁₃ is a single bond or is selected from substituted or unsubstituted C₆-C₂₀ arylene and substituted or unsubstituted C₂-C₂₀ heteroarylene, and k is an integer from 1 to 3, provided that when k is 2 or more, the linkers L₁₃ are identical to or different from each other.

7. The organic electroluminescent device according to claim 4, wherein one or more of the layers are formed by a deposition or solution process.

8. The organic electroluminescent device according to claim 3, wherein the organic electroluminescent device is used in a display or lighting system selected from flat panel displays, flexible displays, monochromatic flat panel lighting systems, white flat panel lighting systems, flexible monochromatic lighting systems, and flexible white lighting systems.

## Patentansprüche

1. Eine organische lichtemittierende Verbindung, dargestellt durch die folgende [Formel A-1], 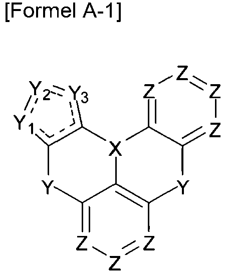 wobei
Y und Y₁ bis Y₃ jeweils unabhängig voneinander ausgewählt sind aus N-R₁, CR₂R₃, O, S, Se und SiR₄R₅, mit der Maßgabe, dass Y und Y₁ bis Y₃ identisch oder voneinander verschieden sind;
gestrichelte Linien eine Einfachbindung oder eine Doppelbindung gemäß der Definition von Y₁ bis Y₃ darstellen;
X ausgewählt ist aus B, P und P=O;
R₁ bis R₅ identisch oder voneinander verschieden sind und jeweils unabhängig voneinander ausgewählt sind aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C2-C50-Heteroarylgruppe, einer substituierten oder unsubstituierten C1 -C30-Alkoxygruppe, einer substituierten oder unsubstituierten C6-C30-Aryloxygruppe, einer substituierten oder unsubstituierten C1-C30-Alkylthioxygruppe, einer substituierten oder unsubstituierten C5-C30-Arylthioxygruppe, einer substituierten oder unsubstituierten C1 -C30-Alkylaminogruppe, einer substituierten oder unsubstituierten C5-C30-Arylaminogruppe, einer substituierten oder unsubstituierten C1-C30-Alkylsilylgruppe, einer substituierten oder unsubstituierten C5-C30-Arylsilylgruppe, einer Nitrogruppe, einer Cyanogruppe und einer Halogengruppe, und
Z gleich CR oder N ist, wobei R ausgewählt ist aus Wasserstoff, Deuterium, einer substituierten oder unsubstituierten C1-C30-Alkylgruppe, einer substituierten oder unsubstituierten C6-C50-Arylgruppe, einer substituierten oder unsubstituierten C3-C30-Cycloalkylgruppe, einer substituierten oder unsubstituierten C2-C50-Heteroarylgruppe, einer substituierten oder unsubstituierten C1 -C30-Alkoxygruppe, einer substituierten oder unsubstituierten C6-C30-Aryloxygruppe, einer substituierten oder unsubstituierten C1-C30-Alkylthioxygruppe, einer substituierten oder unsubstituierten C5-C30-Arylthioxygruppe, einer substituierten oder unsubstituierten C1-C30-Alkylaminogruppe, einer substituierten oder unsubstituierten C5-C30-Arylamin-Gruppe, einer substituierten oder unsubstituierten C1-C30-Alkylsilyl-Gruppe, einer substituierten oder unsubstituierten C5-C30-Arylsilyl-Gruppe, einer Nitro-Gruppe, einer CyanoGruppe und einem Halogen (mit der Maßgabe, dass die Z- und R-Gruppen identisch oder voneinander verschieden sind),
wobei die R-Gruppen miteinander verbunden sein können oder an einen benachbarten Substituenten gebunden sein können, um einen alicyclischen oder aromatischen monocyclischen oder polycyclischen Ring zu bilden, und das Kohlenstoffatom des gebildeten alicyclischen oder aromatischen monocyclischen oder polycyclischen Rings mit mindestens einem Heteroatom substituiert sein kann, das aus N, S und O ausgewählt ist.

2. Die organische lichtemittierende Verbindung gemäß Anspruch 1, wobei [Formel A-1] aus [Verbindung 1] bis [Verbindung 116] ausgewählt ist:

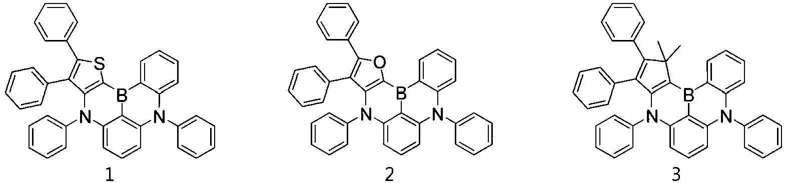

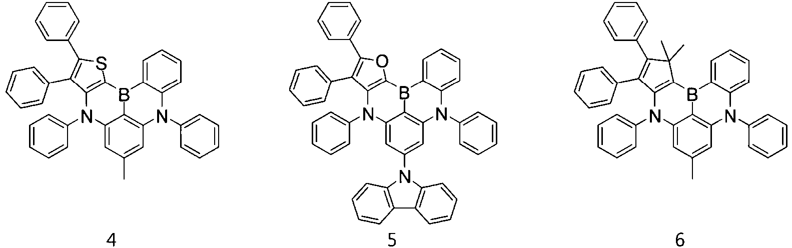

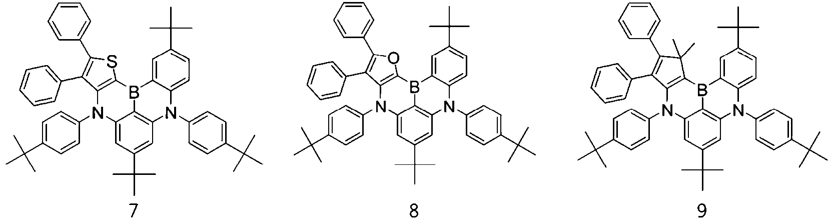

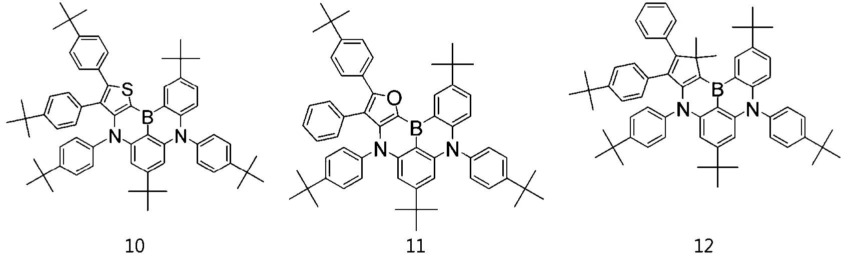

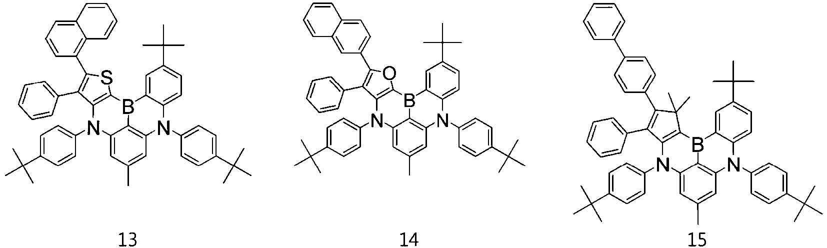

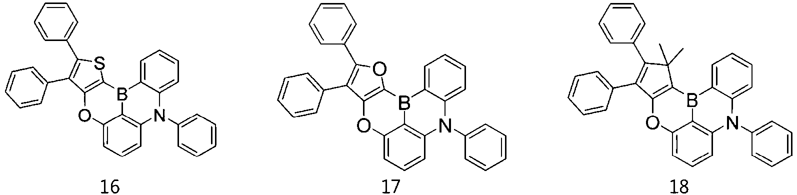

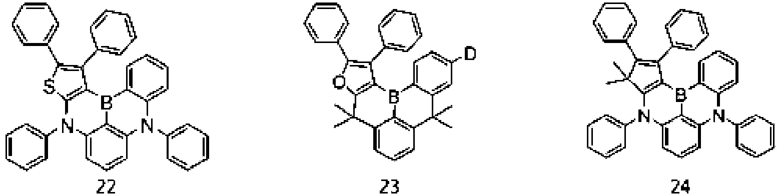

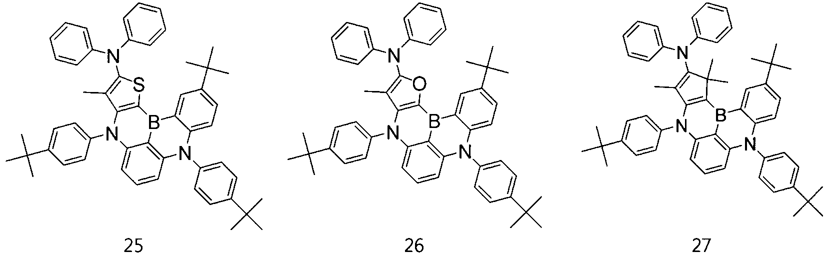

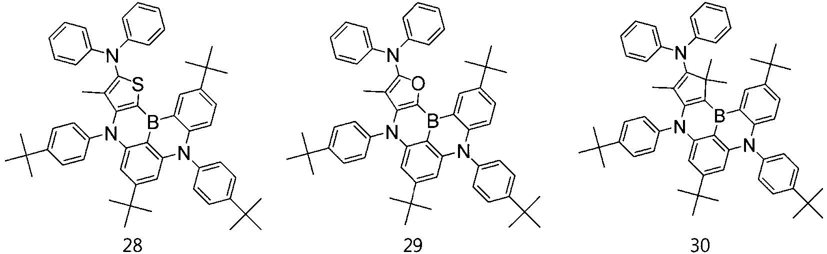

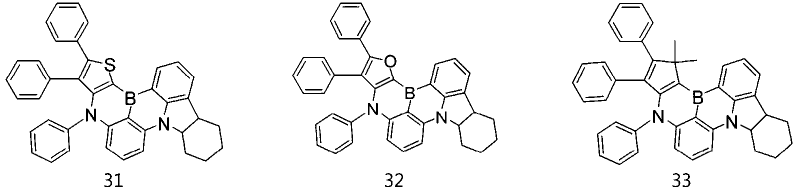

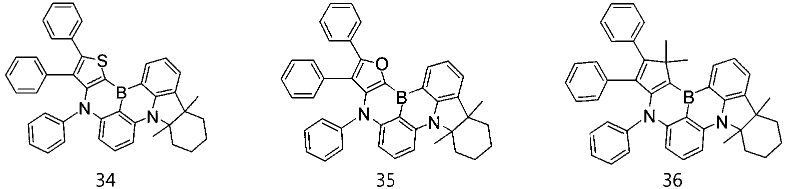

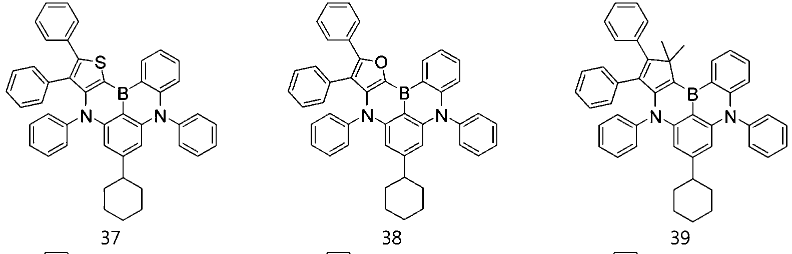

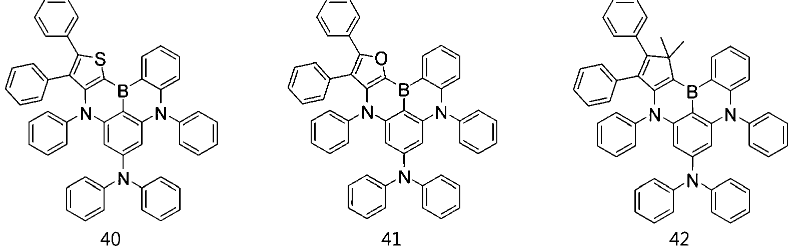

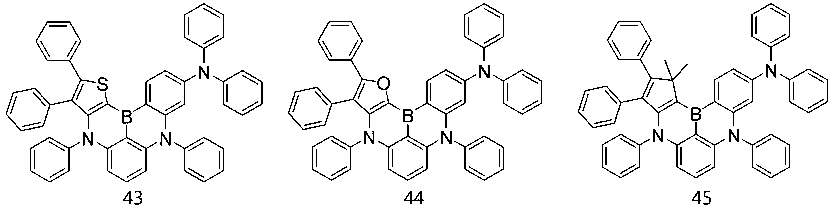

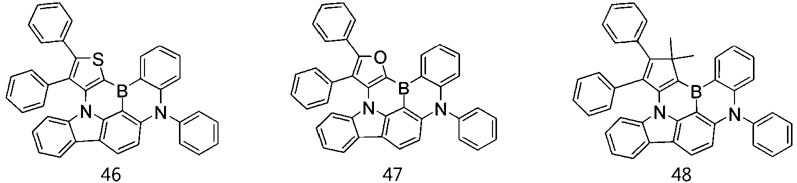

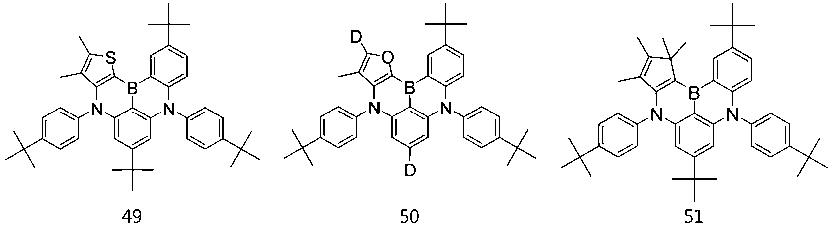

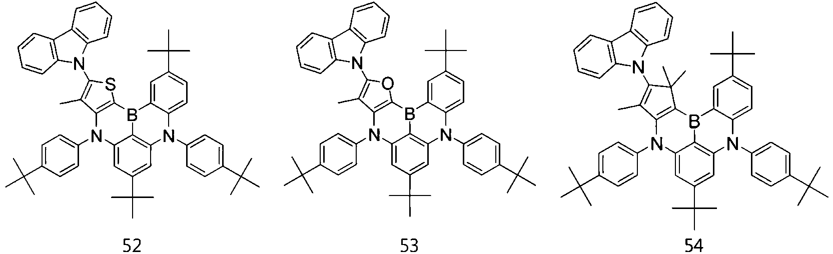

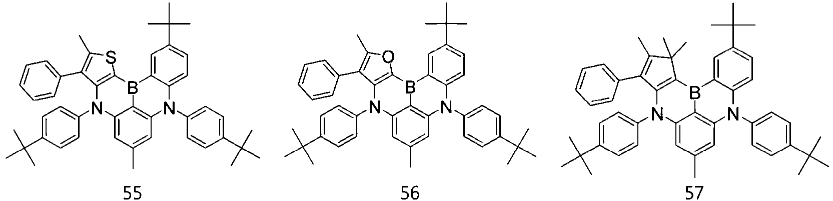

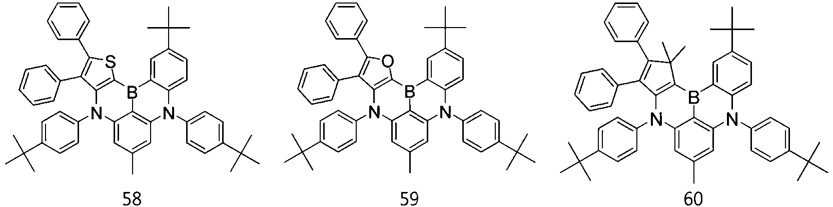

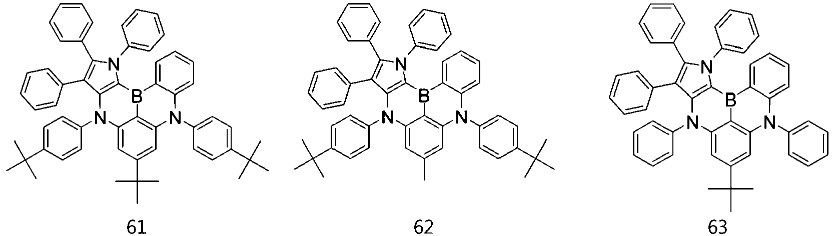

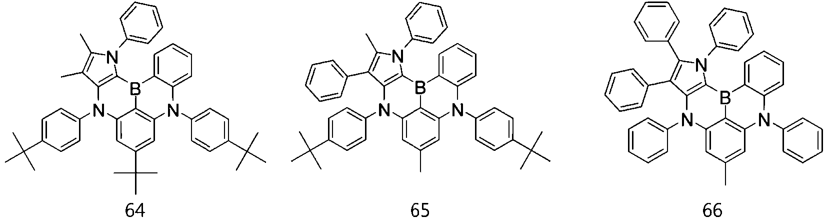

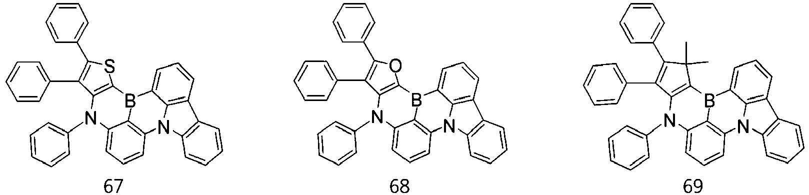

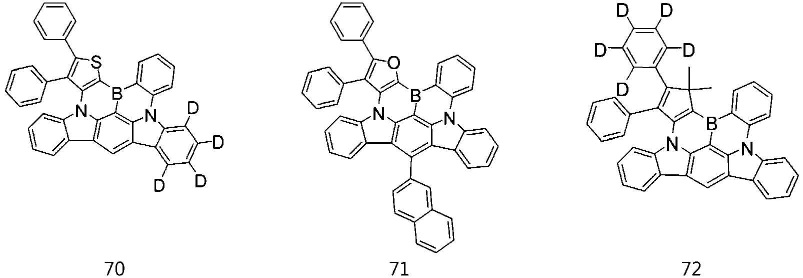

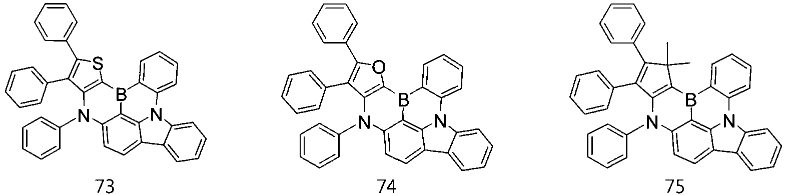

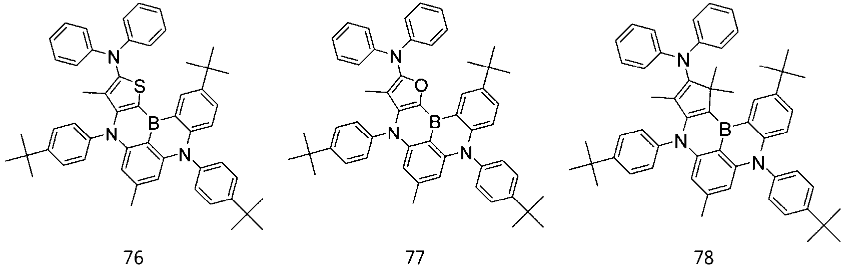

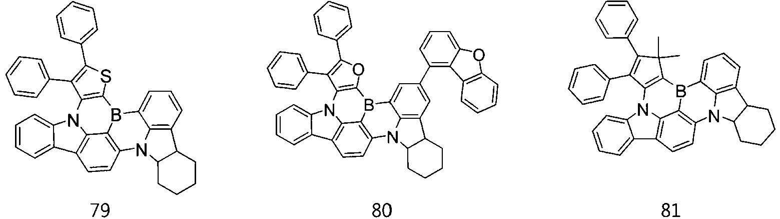

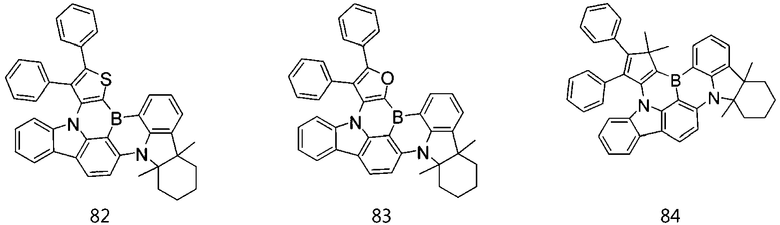

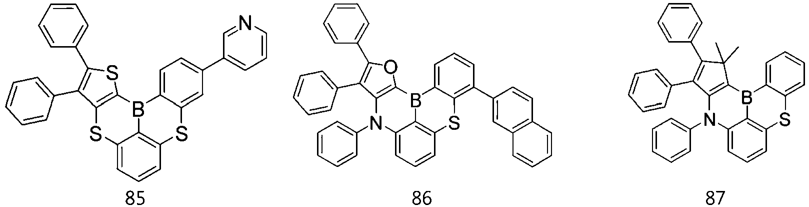

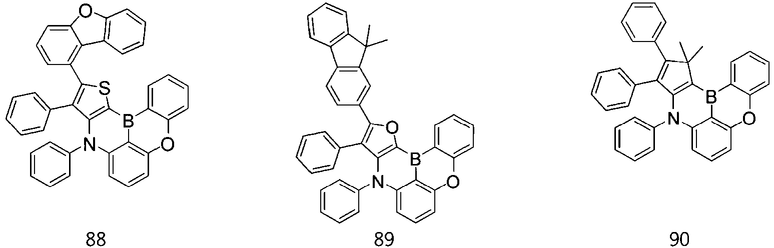

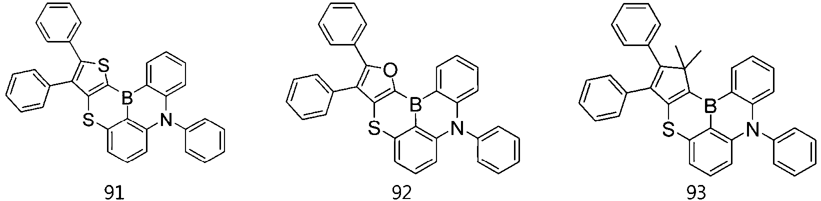

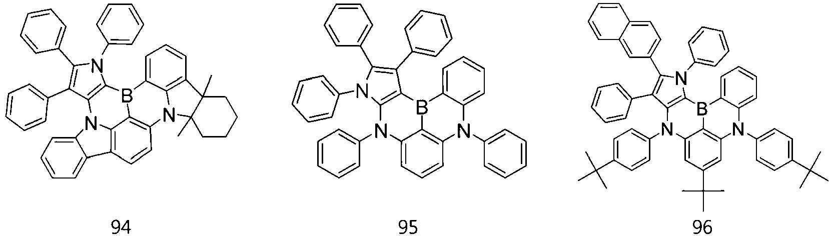

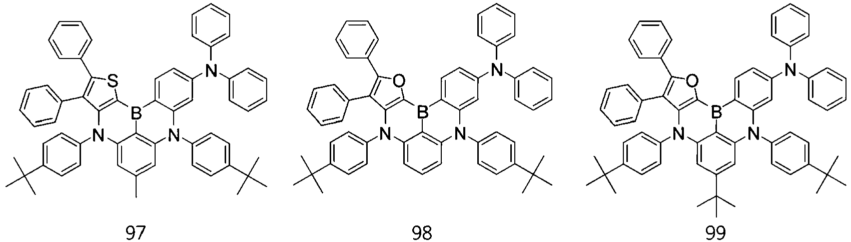

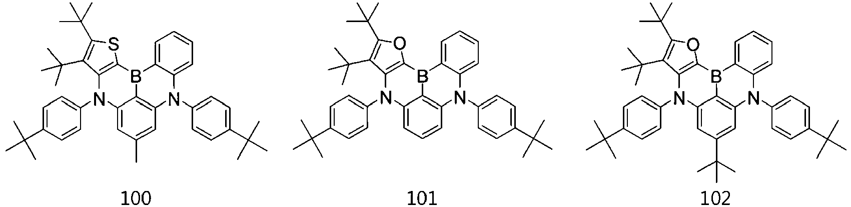

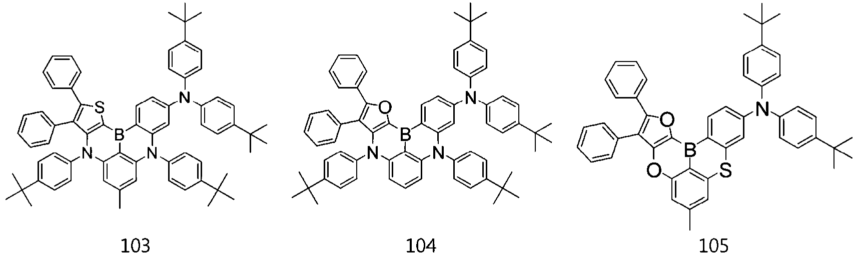

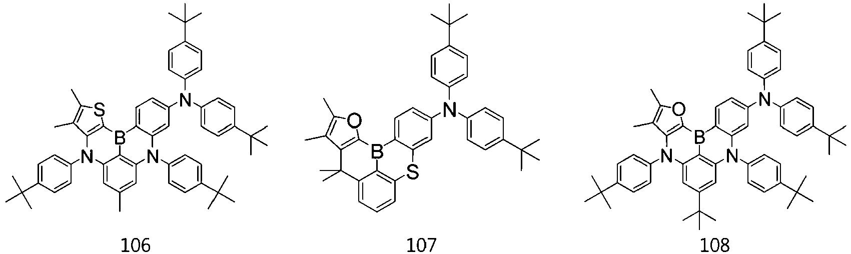

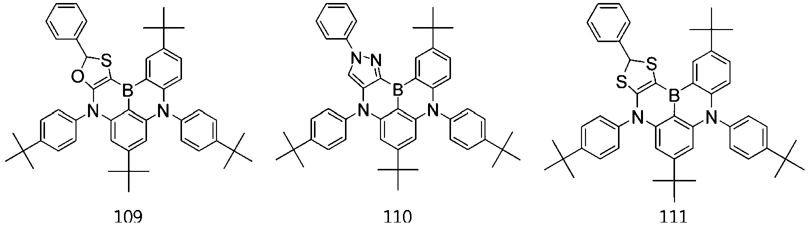

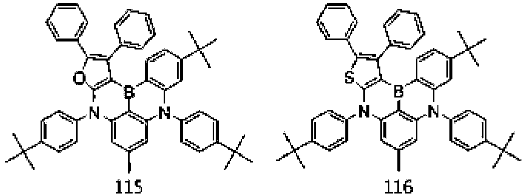

3. Eine organische Leuchtvorrichtung, bestehend aus:
einer ersten Elektrode;
einer zweiten Elektrode, die der ersten Elektrode gegenüberliegt; und
einer organischen Schicht, die zwischen der ersten Elektrode und der zweiten Elektrode angeordnet ist,
wobei die organische Schicht mindestens eine der Verbindungen umfasst, die durch [Formel A-1] gemäß Anspruch 1 dargestellt sind.

4. Die organische Leuchtvorrichtung gemäß Anspruch 3, wobei die organische Schicht mindestens eine der folgenden Schichten umfasst: eine Elektroneninjektionsschicht, eine Elektronentransportschicht, eine Lochinjektionsschicht, eine Lochtransportschicht, eine Elektronenblockierschicht, eine Lochblockierschicht und eine lichtemittierende Schicht,
wobei mindestens eine der Schichten die durch [Formel A-1] dargestellte organische lichtemittierende Verbindung umfasst.

5. Die organische Leuchtvorrichtung gemäß Anspruch 3, wobei die zwischen der ersten Elektrode und der zweiten Elektrode angeordnete organische Schicht eine lichtemittierende Schicht umfasst, die lichtemittierende Schicht einen Wirtsstoff und einen Dotierstoff umfasst und die durch [Formel A-1] dargestellte Verbindung als Dotierstoff verwendet wird.

6. Die organische Leuchtvorrichtung gemäß Anspruch 5, wobei die lichtemittierende Schicht als Wirtsstoff ein Anthranderivat der Formel C umfasst: 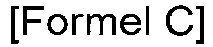 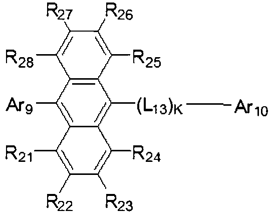 wobei R₂₁ bis R₂₈ identisch oder voneinander verschieden sind und wie für R₁ bis R₁₃ in Formel A-1 oder A-2 definiert sind, Ar₉ und Ar₁₀ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₂-C₃₀-Alkenyl, substituiertem oder unsubstituiertem C₂-C₂₀-Alkinyl, substituiertem oder unsubstituiertem C₃-C₃₀-Cycloalkyl, substituiertem oder unsubstituiertem C₅-C₃₀-Cycloalkenyl, substituiertem oder unsubstituiertem C₂-C₅₀-Heteroaryl, substituiertem oder unsubstituiertem C₂-C₃₀-Heterocycloalkyl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₆-C₃₀-Arylthioxy, substituiertem oder unsubstituiertem C₁-C₃₀-Alkylamin, substituiertem oder unsubstituiertem C₆-C₃₀-Arylamin, substituiertem oder unsubstituiertem C₁-C₃₀-Alkylsilyl und substituiertem oder unsubstituiertem C₆-C₃₀-Arylsilyl, L₁₃ eine Einfachbindung ist oder aus substituiertem oder unsubstituiertem C₆-C₂₀-Arylen und substituiertem oder unsubstituiertem C₂-C₂₀-Heteroarylen ausgewählt ist, und k eine ganze Zahl von 1 bis 3 ist, mit der Maßgabe, dass, wenn k 2 oder mehr ist, die Linker L₁₃ identisch oder voneinander verschieden sind.

7. Die organische Leuchtvorrichtung gemäß Anspruch 4, wobei eine oder mehrere der Schichten durch einen Abscheidungs- oder Lösungsprozess gebildet werden.

8. Die organische Leuchtvorrichtung gemäß Anspruch 3, wobei die organische Leuchtvorrichtung in einem Anzeigegerät oder Beleuchtungssystem verwendet wird, das aus Flachbildschirmen, flexiblen Anzeigegeräten, monochromatischen Flachbildschirm-Beleuchtungssystemen, weißen Flachbildschirm-Beleuchtungssystemen, flexiblen monochromatischen Beleuchtungssystemen und flexiblen weißen Beleuchtungssystemen ausgewählt ist.

## Revendications

1. Composé électroluminescent organique représenté par la [formule A-1] suivante, 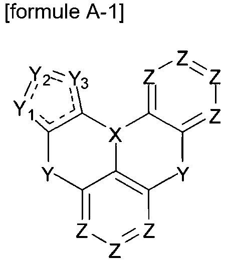
Y, et Y₁ à Y₃ étant chacun indépendamment choisis parmi N-R₁, CR₂R₃, O, S, Se et SiR₄R₅, sous réserve que les Y's, et les Y₁'s à Y₃'s sont identiques ou différents les uns des autres ;
les lignes pointillées représentant une liaison simple ou une liaison double selon la définition de Y₁ à Y₃;
X étant choisi parmi B, P, et P=O;
R₁ à R₅ étant identiques ou différents les uns des autres et étant chacun indépendamment choisi parmi hydrogène, deutérium, un groupe alkyle en C1-C30 substitué ou non substitué, un groupe aryle en C6-C50 substitué ou non substitué, un groupe cycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C5-C30 substitué ou non substitué, un groupe alkylamine en C1-C30 substitué ou non substitué, un groupe arylamine en C5-C30 substitué ou non substitué, un groupe alkylsilyle en C1-C30 substitué ou non substitué, un groupe arylsilyle en C5-C30 substitué ou non substitué, un groupe nitro, un groupe cyano, et un groupe halogène, et
Z étant CR ou N, R étant choisi parmi hydrogène, deutérium, un groupe alkyle en C₁-C₃₀ substitué ou non substitué, un groupe aryle en C6-C50 substitué ou non substitué, un groupe cycloalkyle en C3-C30 substitué ou non substitué, un groupe hétéroaryle en C2-C50 substitué ou non substitué, un groupe alkoxy en C1-C30 substitué ou non substitué, un groupe aryloxy en C6-C30 substitué ou non substitué, un groupe alkylthioxy en C1-C30 substitué ou non substitué, un groupe arylthioxy en C5-C30 substitué ou non substitué, un groupe alkylamine en C1-C30 substitué ou non substitué, un groupe arylamine en C5-C30 substitué ou non substitué, un groupe alkylsilyle en C1-C30 substitué ou non substitué, un groupe arylsilyle en C5-C30 substitué ou non substitué, un groupe nitro, un groupe cyano, et un halogène (sous réserve que les Z's et les R's sont identiques ou différents les uns des autres),
les R's pouvant être liés les uns aux autres ou pouvant être reliés à un substituant adjacent pour former un monocycle ou polycycle alicyclique ou aromatique, et l'atome de carbone du monocycle ou polycycle alicyclique ou aromatique formé pouvant être substitué par au moins un hétéroatome choisi parmi N, S et O.

2. Composé électroluminescent organique selon la revendication 1, dans lequel la [formule A-1] est choisie parmi [composé 1] à [composé 116] :

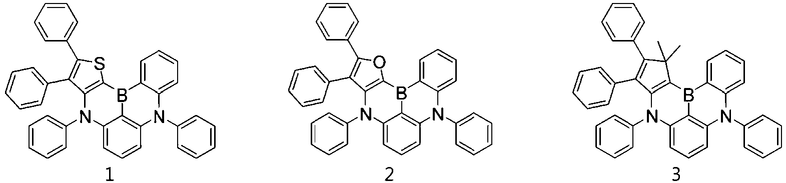

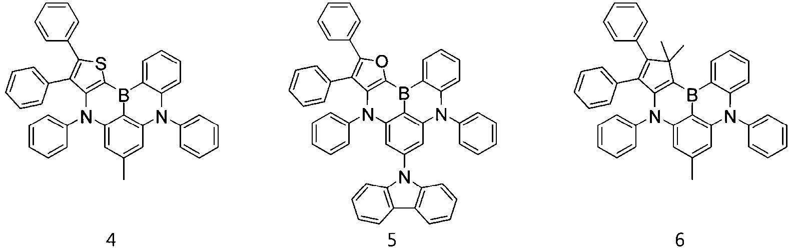

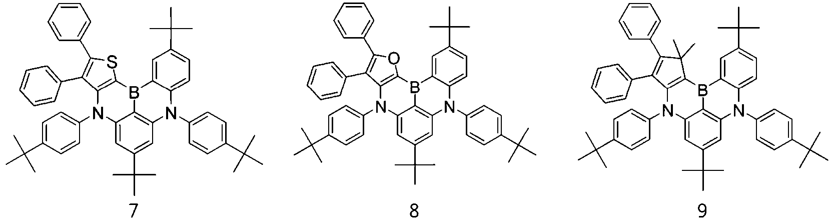

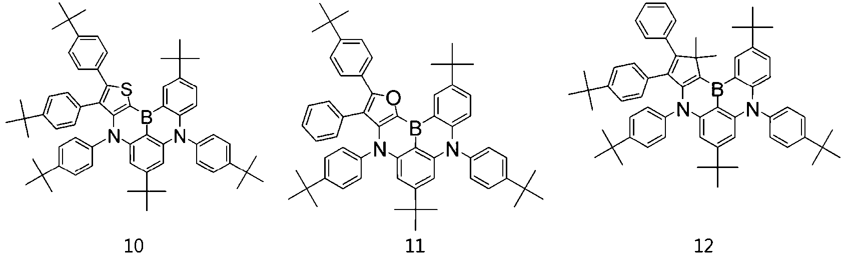

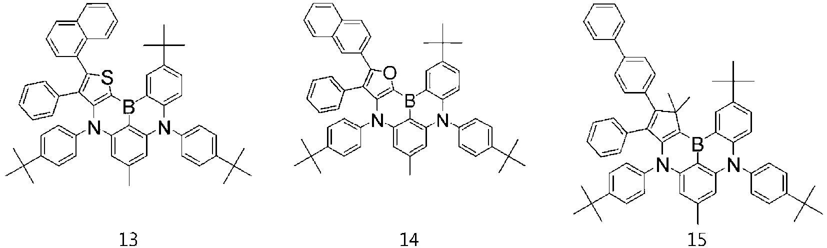

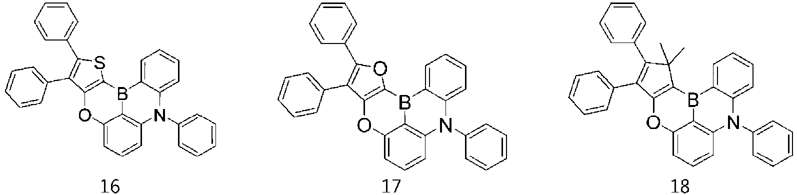

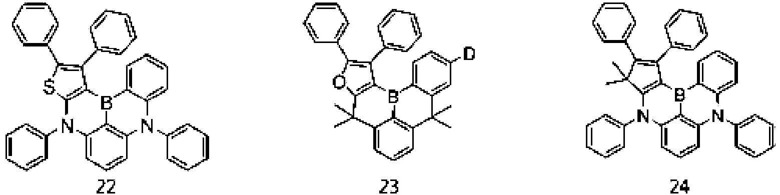

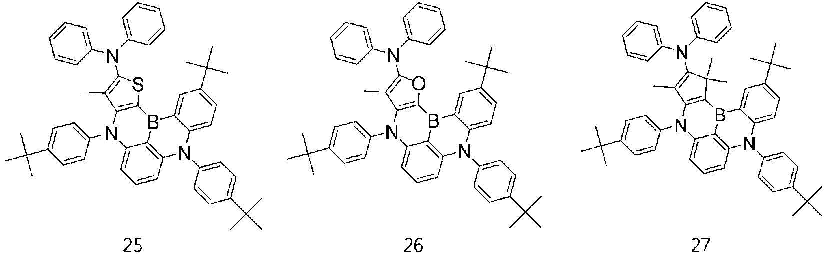

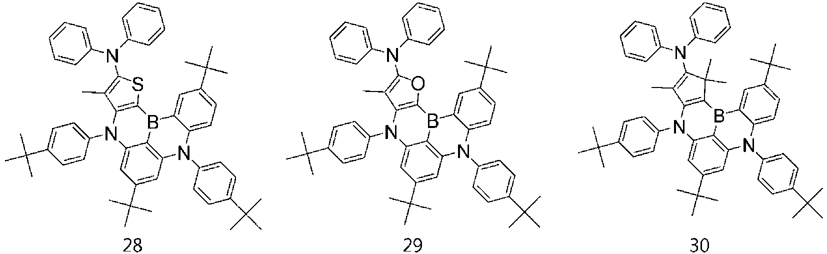

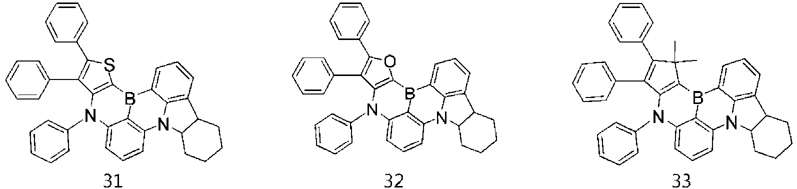

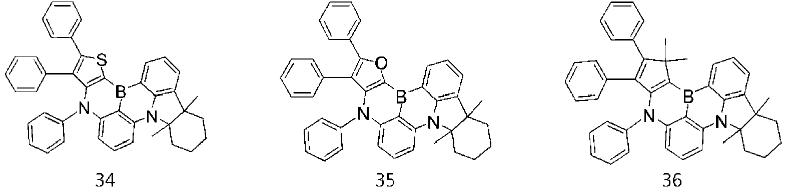

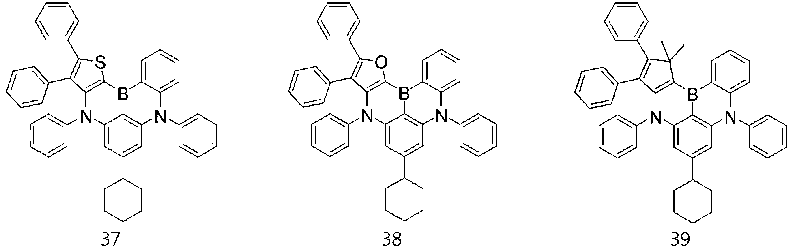

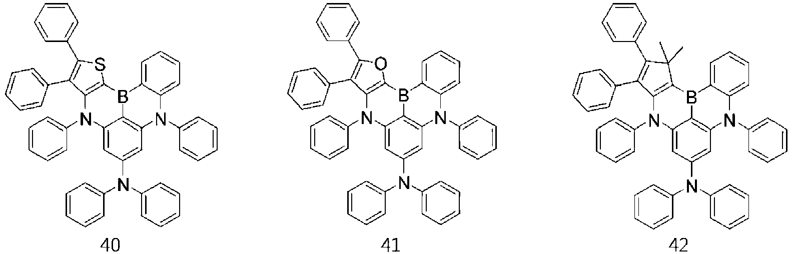

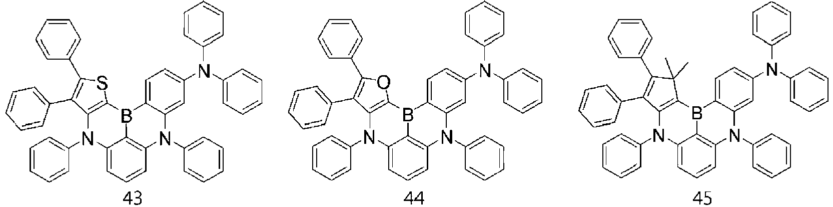

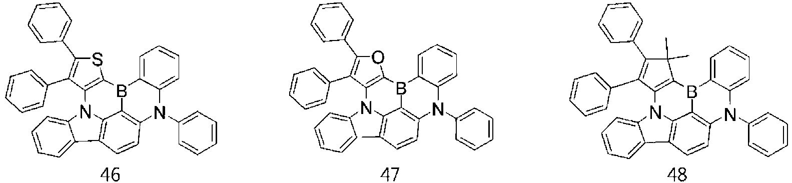

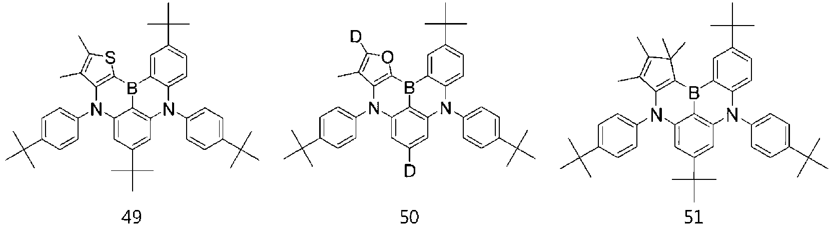

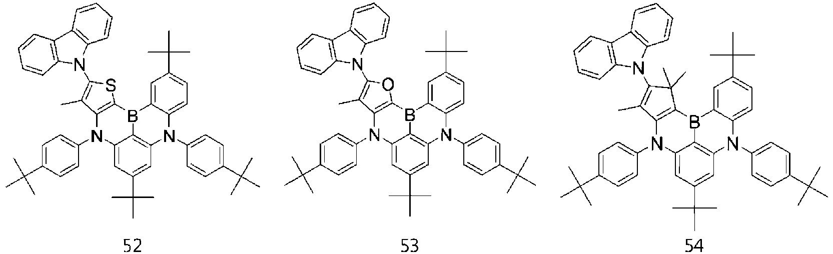

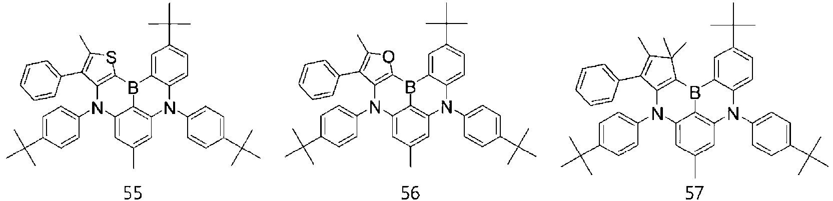

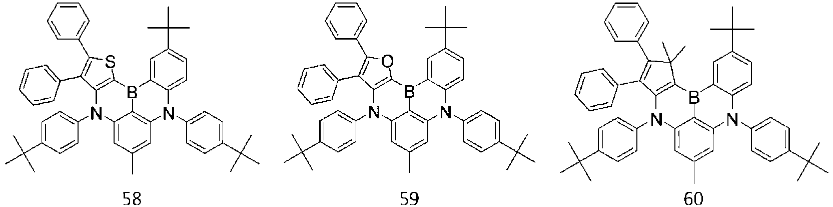

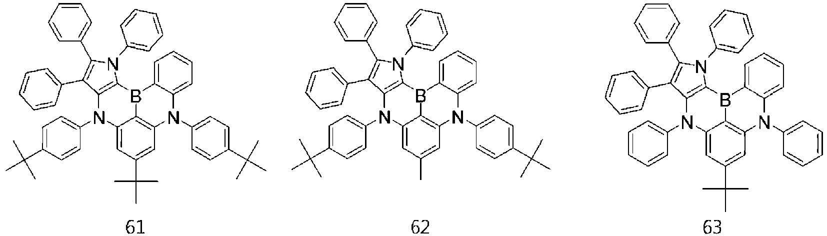

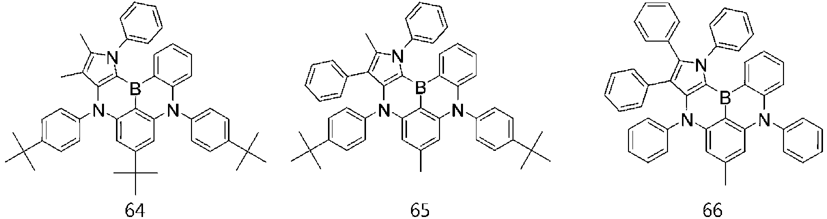

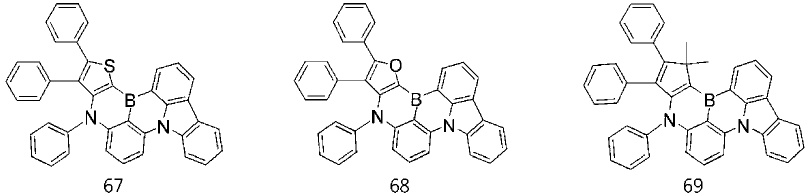

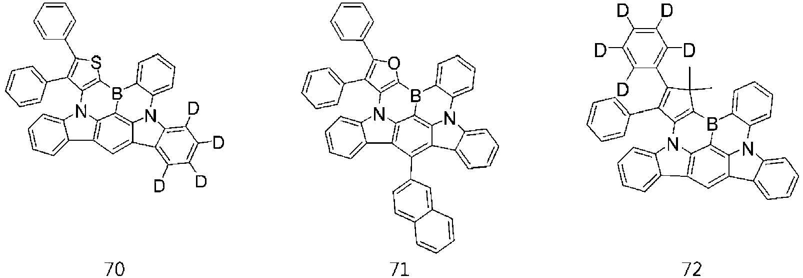

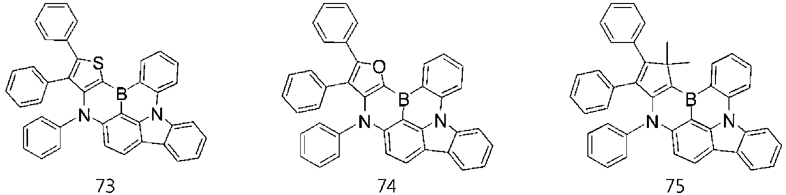

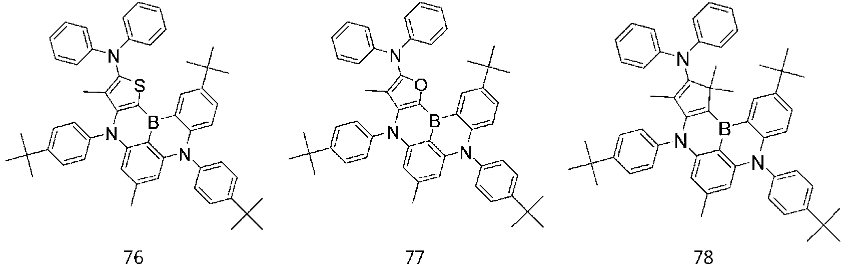

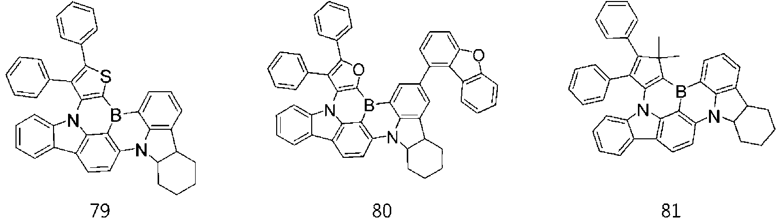

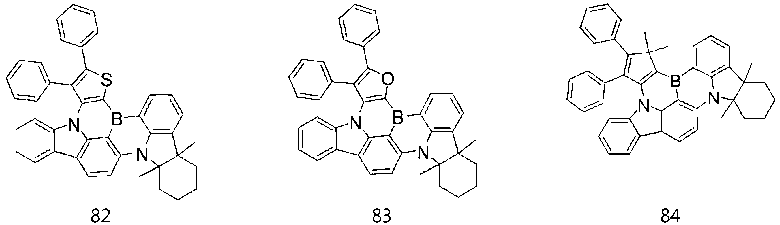

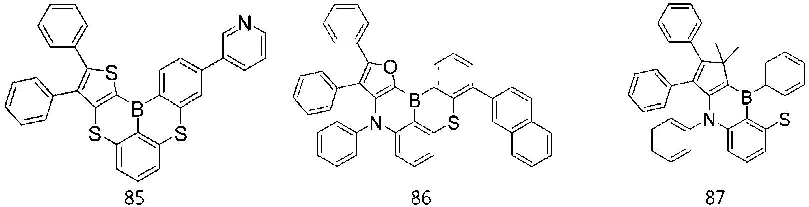

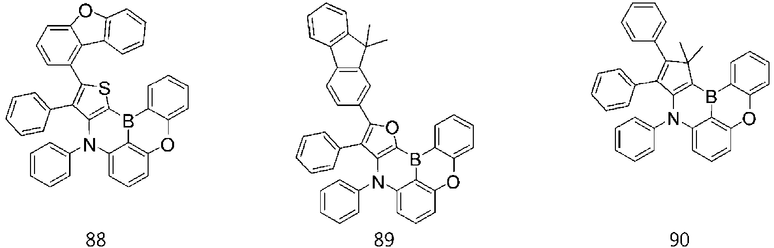

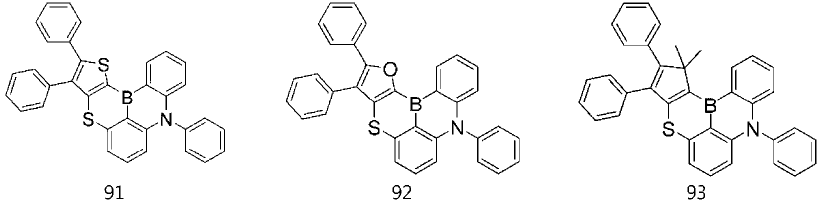

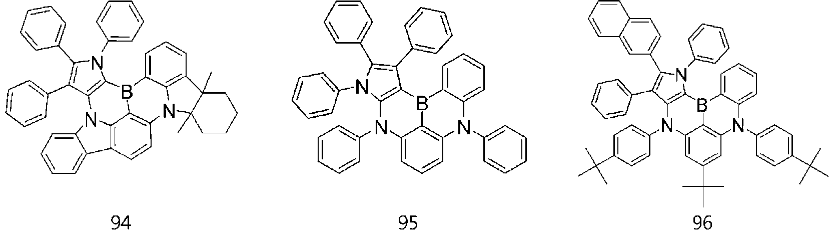

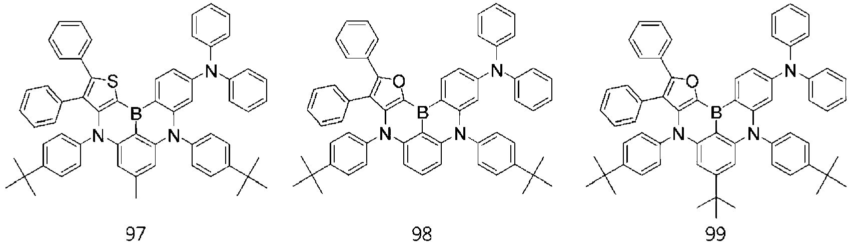

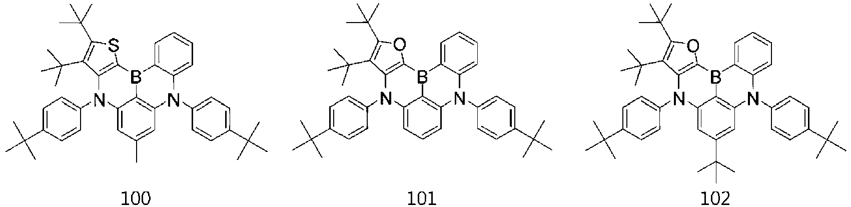

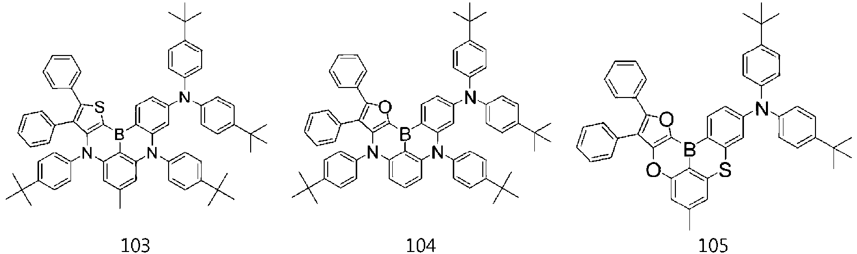

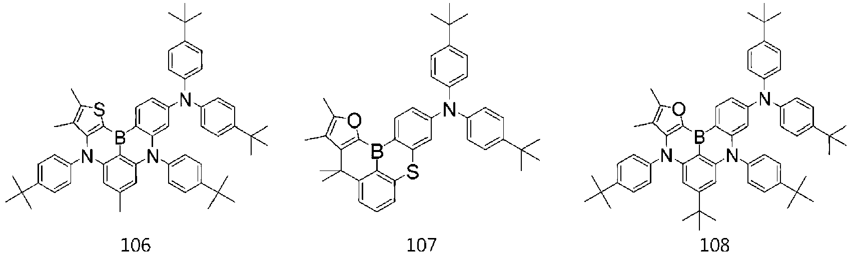

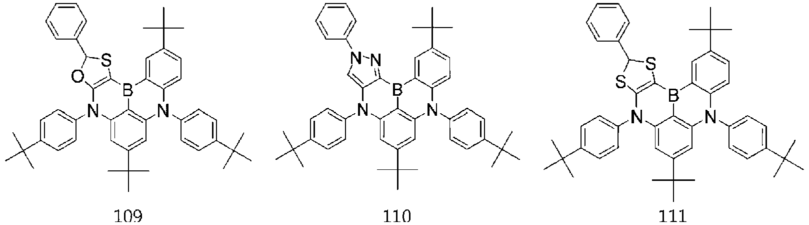

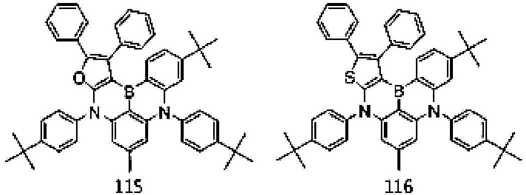

3. Dispositif électroluminescent organique comprenant :
une première électrode ;
une deuxième électrode faisant face à la première électrode ; et
une couche organique interposée entre la première électrode et la deuxième électrode,
la couche organique comprenant au moins un des composés représentés par la [formule A-1] selon la revendication 1.

4. Dispositif électroluminescent organique selon la revendication 3, dans lequel la couche organique comprend au moins une d'une couche d'injection d'électrons, une couche de transport d'électrons, une couche d'injection de trous, une couche de transport de trous, une couche de blocage d'électrons, une couche de blocage de trous, et une couche d'émission de lumière,
au moins une des couches comprenant le composé électroluminescent organique représenté par la [formule A-1].

5. Dispositif électroluminescent organique selon la revendication 3, dans lequel la couche organique interposée entre la première électrode et la deuxième électrode comprend une couche d'émission de lumière, la couche d'émission de lumière comprenant un hôte et un dopant, et le composé représenté par la [formule A-1] étant utilisé en tant que dopant.

6. Dispositif électroluminescent organique selon la revendication 5, dans lequel la couche d'émission de lumière comprend, en tant que composé hôte, un dérivé de l'anthracène représenté par la formule C : 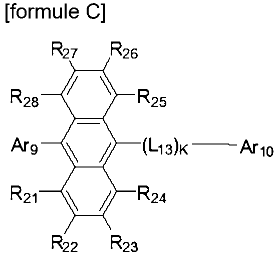 R₂₁ à R₂₈ étant identiques ou différents les uns des autres et étant tels que définis pour R₁ à R₁₃ dans la formule A-1 ou A-2, Ar₉ et Ar₁₀ étant identiques ou différents les uns des autres et étant chacun indépendamment choisi parmi hydrogène, deutérium, un alkyle en C₁-C₃₀ substitué ou non substitué, un aryle en C₆-C₅₀ substitué ou non substitué, un alcényle en C₂-C₃₀ substitué ou non substitué, un alcynyle en C₂-C₂₀ substitué ou non substitué, un cycloalkyle en C₃-C₃₀ substitué ou non substitué, un cycloalcényle en C₅-C₃₀ substitué ou non substitué, un hétéroaryle en C₂-C₅₀ substitué ou non substitué, un hétérocycloalkyle en C₂-C₃₀ substitué ou non substitué, un alkoxy en C₁-C₃₀ substitué ou non substitué, un aryloxy en C₆-C₃₀ substitué ou non substitué, un alkylthioxy en C₁-C₃₀ substitué ou non substitué, un arylthioxy en C₆-C₃₀ substitué ou non substitué, un alkylamine en C₁-C₃₀ substituée ou non substituée, un arylamine en C₆-C₃₀ substituée ou non substituée, un alkylsilyle en C₁-C₃₀ substitué ou non substitué, et un arylsilyle en C₆-C₃₀ substitué ou non substitué, L₁₃ étant une liaison simple ou étant choisi parmi un arylène en C₆₋C₂₀ substitué ou non substitué et un hétéroarylène en C₂-C₂₀ substitué ou non substitué, et k étant un entier compris entre 1 et 3, pourvu que, lorsque k est égal ou supérieur à 2, les liants L₁₃ sont identiques ou différents les uns des autres.

7. Dispositif électroluminescent organique selon la revendication 4, dans lequel une ou plusieurs des couches sont formées par un processus de déposition ou un processus de solution.

8. Dispositif électroluminescent organique selon la revendication 3, ledit dispositif électroluminescent organique étant utilisé dans un système d'affichage ou d'éclairage choisi parmi des écrans à panneau plat, des écrans flexibles, des systèmes d'éclairage monochromatique à panneau plat, des systèmes d'éclairage blanc à panneau plat, des systèmes flexibles d'éclairage monochromatique, et des systèmes flexibles d'éclairage blanc.
